(19) Europäisches Patentamt European Patent Office Office européen des brevets

(11) **EP 1 783 900 A1**

(12) **EUROPEAN PATENT APPLICATION**
published in accordance with Art. 158(3) EPC

(43) Date of publication:
**09.05.2007 Bulletin 2007/19**

(51) Int Cl.:
*H03H 7/09* (2006.01)   *H04B 3/56* (2006.01)

(21) Application number: **05770436.3**

(22) Date of filing: **09.08.2005**

(86) International application number:
**PCT/JP2005/014565**

(87) International publication number:
**WO 2006/019011 (23.02.2006 Gazette 2006/08)**

(84) Designated Contracting States:
**DE ES**

(30) Priority: **20.08.2004   JP 2004240301**

(71) Applicant: **TDK Corporation**
**Tokyo 103-8272 (JP)**

(72) Inventors:
• **Saitoh, Yoshihiro**
**c/o TDK Corporation**
**Tokyo 1038272 (JP)**

• **Ishibashi, Mitsuru**
**c/o TDK Corporation**
**Tokyo 1038272 (JP)**

(74) Representative: **Hoffmann, Jörg Peter**
**Müller Hoffmann & Partner**
**Patentanwälte**
**Innere Wiener Strasse 17**
**81667 München (DE)**

(54) **NOISE SUPPRESSING CIRCUIT**

(57)   The present invention realizes a noise suppression circuit capable of suppressing noise in a wide frequency range even if impedance fluctuates on the input side or the output side. A noise suppression circuit has first and second inductors (L1, L2) inserted in series in a first conductive line (3), and a series circuit (15) configured to have a third inductor (L3) and a first capacitor (C1) connected in series. The third inductor (L3) side is connected between the first and second inductors (L1, L2). The noise suppression circuit further includes a second capacitor (C2) whose one end is connected to the first conductive line (3) on the first inductor (L1) side and whose other end is connected between the third inductor and the first capacitor in the series circuit (15).

FIG. 1A

**EP 1 783 900 A1**

FIG. 1B

## Description

Technical Field

The present invention relates to a noise suppression circuit for suppressing noise propagating through a conductive line.

Background Art

A power electronic device such as a switching power supply, an inverter, a lighting circuit of a lighting device, or the like has a power converting circuit for converting power. The power converting circuit has a switching circuit for converting direct current to alternating current having rectangular waveforms. Consequently, the power converting circuit generates a ripple voltage having a frequency equal to the switching frequency of the switching circuit, and noise accompanying the switching operation of the switching circuit. The ripple voltage and noise exerts adverse influence on the other devices. It is therefore necessary to provide means for reducing the ripple voltage and noise between the power converting circuit and the other devices or a line.

Recently, power-line communication is regarded as a promising communication technique which is used at the time of configuring a communication network in a house, and is being developed. In the power-line communication, communication is performed by multiplexing a high frequency signal on a power line. In the power-line communication, noise occurs on a power line due to operations of various electric/electronic devices connected to the power line, and it causes deterioration in communication quality such as increase in the error rate. Consequently, means for reducing noise on the power line is necessary. In the power-line communication, it is necessary to prevent a communication signal on an indoor power line from leaking to an outdoor power line.

To suppress the noise, it is effective to provide a power line, a signal line, or the like with a line filter. As a line filter, a filter including an inductance element (inductor) and a capacitor, a so-called LC filter is often used. The LC filters include a filter having one inductance element and one capacitor, a T filter, and a π filter. A common noise filter for preventing electromagnetic interference (EMI) is one of the LC filters. A general EMI filter is configured by combining discrete elements such as a common-mode choke coil, a normal-mode choke coil, an X capacitor, a Y capacitor, and the like.

The noise propagating through two conductive lines includes normal-mode (differential-mode) noise causing a potential difference between the two conductive lines and common-mode noise propagating in the same phase in the two conductive lines.

Patent document 1 describes a low-pass filter including three impedance elements. The low-pass filter has two high-impedance elements inserted in series in one of two conductive lines, and a low-impedance element whose one end is connected between the two high-impedance elements and whose other end is connected to the other one of the two conductive lines. Each of the two high-impedance elements includes a parallel connection circuit of a coil and a resistor, and the low-impedance element includes a capacitor. The low-pass filter reduces the normal-mode noise.

A conventional LC filter has a peculiar resonance frequency determined by inductance and capacitance and has therefore a problem such that desired attenuation can be obtained only in a narrow frequency range. Since the low-pass filter described in Patent Document 1 has a noise reduction principle similar to that of the conventional LC filter, it also has a problem similar to that of the conventional LC filter.

Patent Document 2 describes a T filter. Fig. 33 shows an equivalent circuit of the T filter. The circuit has first and second inductors L101 and L102 inserted in series in a first conductive line 103, having the same polarity, and electromagnetically coupled to each other. The circuit also has a series circuit 115 including a third inductor L103 and a first capacitor C101 connected in series, whose one end is connected between the first and second inductors L101 and L102, and whose other end is connected to a second conductive line 104.

Patent Document 1: Japanese Patent Laid-open (JP-A) No. H5-121988 (Fig. 1)
Patent Document 2: JP-A No. H10-200357 (Fig. 2A)

Disclosure of the Invention

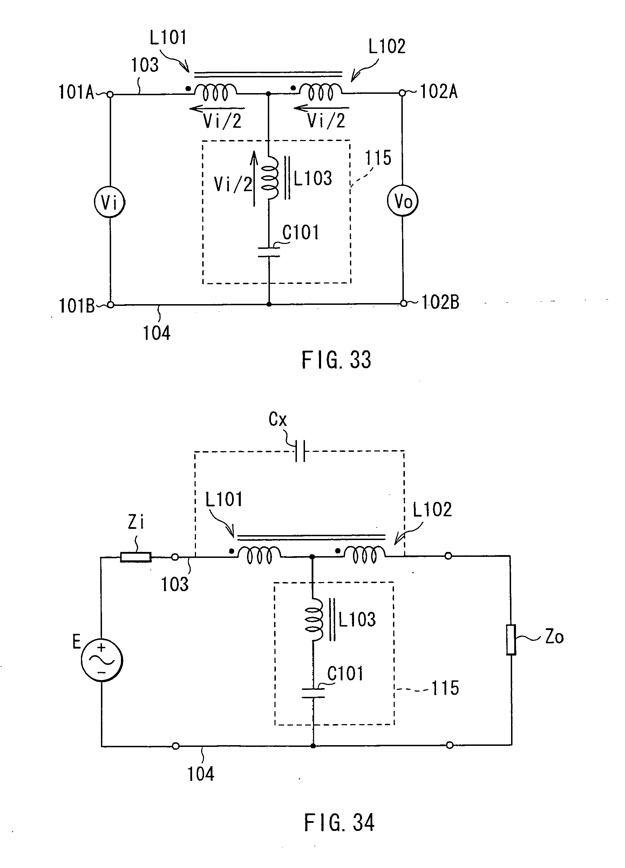

The ideal conditions for reducing the normal-mode noise in the circuit shown in Fig. 33 are as follows. First, the inductance of the first and second inductors L101 and L102 is set to have the same value, and the coupling coefficient is set to 1. The inductance of the third inductor L103 in the series circuit 115 is also set to have the same value as that of the first and second inductors L101 and L102. The first capacitor C101 functions as a high-pass filter for checking direct current and current in a low frequency range. It is assumed that the impedance of the first capacitor C101 is so low as to be insignificant.

When a voltage Vi in the normal mode is applied across the input terminals 101A and 101B in the ideal circuit conditions as shown in Fig. 33, the voltage Vi is divided by the first inductor L101 and the third inductor L103 in the series circuit 115, and a voltage Vi/2 develops across the first inductor L101 and across the third inductor L103. Each of the arrows in the diagram shows that the potential at the pointing side is higher. Since the first inductor L101 and the second inductor L102 are electromagnetically coupled to each other, the voltage Vi/2 is generated also across the second inductor L102 in accordance with the voltage Vi/2 developed across the first inductor L101. As a result, since the voltage Vi/2 generated across the second inductor L102 and the voltage Vi/2 across the third inductor L103 cancel out each other, a voltage Vo between output terminals 102A and 102B becomes zero in theory. Also in the case where a voltage in the normal mode is applied across the output terminals 102A and 102B, in a manner similar to the above, the voltage across the input terminals 101A and 101B becomes zero in theory. In such a manner, the normal-mode noise can be suppressed.

However, under actual circuit conditions, stray capacitance Cx exists in parallel with the first and second inductors L101 and L102 as shown in Fig. 34 and the input/output impedance of signals varies with time. There is consequently a problem such that an ideal noise suppression effect cannot be obtained.

For example, in Fig. 34, E denotes a noise source, Zi denotes impedance on a signal input side, and Zo indicates impedance on a signal output side. Under actual circuit conditions, in some cases, particularly, the impedance Zi on the noise source E fluctuates with time due to switching operation and the like. In an environment where the impedance becomes high, the action of inductance components of the first and second inductors L101 and L102 becomes weak and, in an extreme case, signals pass freely. In this case, only a noise suppression effect by the action of the stray capacitance Cx, not the inherent function of the noise suppression circuit, or the series resonance action in the series circuit 115 is obtained. Although a parallel resonance circuit is formed by the first and second inductors L101 and L102 and the stray capacitance Cx under actual circuit conditions, in particular, a high frequency characteristic in a frequency region at or higher than the resonance point of the parallel resonance circuit tends to deteriorate conspicuously due to the fluctuations in the input/output impedance. Those problems can be allowed to a certain extent when an object is to obtain only a noise suppression effect in a narrow band, but are unignorable when an object is to obtain a noise suppression effect in a wide band.

The present invention has been achieved in view of the problems and it is desirable to provide a noise suppression circuit capable of excellently suppressing noise in a wide frequency range even if impedance fluctuates on the input side or output side.

A noise suppression circuit according to a first aspect of the invention is a circuit suppressing normal-mode noise transmitted on first and second conductive lines and causing a potential difference between the first and the second conductive lines and including: first and second inductors inserted in series in the first conductive line and electromagnetically coupled to each other; a first series circuit in which a third inductor and a first capacitor are connected in series, the third inductor side of the first series circuit is connected between the first and second inductors, and the first capacitor side of the first series circuit is connected to the second conductive line; and a second capacitor whose one end is connected to the first conductive line on one end side of a series inductor section configured of the first and the second inductors and whose other end is connected between the third inductor and the first capacitor in the first series circuit.

The noise suppression circuit according to the first aspect of the invention is formed as an unbalanced noise suppression circuit suppressing the normal-mode noise. By having the second capacitor whose one end is connected to the first conductive line on the first inductor side or the second inductor side and whose other end is connected between the third inductor and the first capacitor in the first series circuit, disturbance of the inherent operation of the noise suppression circuit by stray capacitance generated in parallel with the first and second inductors and deterioration of the high frequency characteristic due to fluctuations in the input/output impedance is suppressed. For example, also in the case where the impedance becomes high and the action of the inductance components of the first and second inductors becomes weaker, a part of current flowing in the first and second inductors passes through the second capacitor, thereby preventing deterioration in the characteristic. Consequently, even if the impedance fluctuates on the input side or the output side, the normal-mode noise can be suppressed excellently in a wide frequency range.

This case is preferable since an excellent characteristic adapted to all of impedances is obtained by adjusting the inductance IL of the third inductor in the first series circuit and the capacitance sC of the second capacitor so as to satisfy the following conditions. Specifically, when overall inductance of a combination of the first and second inductors is LL, the inductance of the third inductor in the first series circuit is IL, the capacitance of the first capacitor in the first series circuit is dC, and the capacitance of the second capacitor is sC, preferably, the inductance of the first and second inductors is LL/4 and has the same value, and the following conditions are satisfied.

$$0 < IL < LL/4 \ ... \ (A\text{-}1)$$

$$0 < sC < dC \ ... \ (B\text{-}1)$$

The noise suppression circuit according to the first aspect of the invention may further include: fourth and fifth inductors inserted in series in the second conductive line and electromagnetically coupled to each other; a second series circuit in which a sixth inductor and a third capacitor are connected in series, the sixth inductor side of the second series circuit is connected between the fourth and fifth inductors, and the third capacitor side of the second series circuit is connected to the first conductive line; and a fourth capacitor whose one end is connected to the second conductive line on one end side of a series inductor section configured of the fourth and the fifth inductors and whose other end is connected between the sixth inductor and the third capacitor in the second series circuit. In this case, the first capacitor side of the first series circuit is connected to the second conductive line on the opposite side of a series inductor section configured of the fourth and fifth inductors from the side to which one end of the fourth capacitor is connected. The third capacitor side of the second series circuit is connected to the first conductive line on the opposite side of a series inductor section configured of the first and second inductors from the side to which one end of the second capacitor is connected.

This case is preferable since an excellent characteristic adapted to all of impedances is obtained by adjusting the inductance IL of the third inductor in the first series circuit and the sixth inductor in the second series circuit and the capacitance sC of the second and fourth capacitors so as to satisfy the following conditions. Specifically, when the sum of overall inductance of a combination of the first and second inductors and overall inductance of a combination of the fourth and fifth inductors is LL, each of the inductance of the third inductor in the first series circuit and the inductance of the sixth inductor in the second series circuit is IL, each of the capacitance of the first capacitor in the first series circuit and the capacitance of the third capacitor in the second series circuit is dC, and each of the capacitance of the second capacitor and the capacitance of the fourth capacitor is sC, preferably, the inductance of the first and second inductors and the inductance of the fourth and fifth inductors is LL/8 and has the same value, and the following conditions are satisfied.

$$0 < IL/2 < LL/8 \qquad \dots (A\text{-}2)$$

$$0 < sC < dC \quad \dots (B\text{-}2)$$

The noise suppression circuit may further include a fifth capacitor whose one end is connected to the second conductive line on the first capacitor side of the first series circuit, and whose other end is connected to the first conductive line on the third capacitor side of the second series circuit. With the configuration, a more excellent signal characteristic is obtained.

A noise suppression circuit according to a second aspect of the invention is a circuit suppressing normal-mode noise transmitted on first and second conductive lines and causing a potential difference between the first and the second conductive lines, including: first and second inductors inserted in series in the first conductive line and electromagnetically coupled to each other; third and fourth inductors inserted in series in the second conductive line and electromagnetically coupled to each other; a series circuit including a fifth inductor whose one end is connected between the first and second inductors, a first capacitor whose one end is connected to the other end of the fifth inductor, and a sixth inductor whose one end is connected to the other end of the first capacitor and whose other end is connected between the third and fourth inductors; a second capacitor whose one end is connected to the first conductive line on one side of a series inductor section configured of the first and the second inductors and whose other end is connected between the fifth inductor and the first capacitor in the series circuit; and a third capacitor whose one end is connected to the second conductive line on one side of a series inductor section configured of the third and the forth inductors, the one side corresponding to a connection point of the second capacitor to the first conductive line, and whose other end is connected between the sixth inductor and the first capacitor in the series circuit.

The noise suppression circuit according to the second aspect of the invention is formed as a balanced noise suppression circuit suppressing normal-mode noise. The second capacitor whose one end is connected to the first conductive line and whose other end is connected between the fifth inductor and the first capacitor in the series circuit, and the third capacitor whose one end is connected to the second conductive line and whose other end is connected between the sixth inductor and the first capacitor in the series circuit are provided. Consequently, disturbance of the inherent operation of the noise suppression circuit by stray capacitance generated in parallel with the first and second inductors and stray capacitance generated in parallel with the third and fourth inductors and deterioration of the high frequency characteristic due to fluctuations in the input/output impedance is suppressed. For example, also in the case where the impedance becomes high and the action of the inductance components of the first and second inductors becomes weaker, a part of current flowing in the first and second inductors passes through the second capacitor, thereby preventing deterioration in the characteristic. Similarly, also in the case where the action of the inductance components of the third and fourth inductors becomes weaker, a part of current flowing in the third and fourth inductors passes through the third capacitor, thereby preventing deterioration in the characteristic. Thus, even if the impedance fluctuates on the input side or the output side, the normal-mode noise can be suppressed excellently in a wide frequency range.

This case is preferable since an excellent characteristic adapted to all of impedances is obtained by adjusting the inductance IL of the fifth and sixth inductors in the series circuit and the capacitance sC of the second and third capacitors so as to satisfy the following conditions. Specifically, when the sum of overall inductance of a combination of the first and second inductors and overall inductance of a combination of the third and fourth inductors is LL, each of the inductance of the fifth inductor and the inductance of the sixth inductor in the series circuit is IL, the capacitance of the first capacitor in the series circuit is dC, and each of the capacitance of the second capacitor and the capacitance of the third capacitor is sC, preferably, the inductance of the first and second inductors and the inductance of the third and fourth inductors is LL/8 and has the same value, and the following conditions are satisfied.

$$0 < IL/2 < LL/8 \quad \dots (A\text{-}3)$$

$$0 < sC < dC/2 \dots (B\text{-}3)$$

In the noise suppression circuit according to the second aspect of the invention, the first and second inductors and the third and fourth inductors may be electromagnetically coupled to each other. This case is preferable since an excellent characteristic adapted to all of impedances is obtained by adjusting the inductance IL of the fifth and sixth inductors in the series circuit and the capacitance sC of the second and third capacitors so as to satisfy the following conditions. Specifically, when the overall inductance of a combination of the first and second inductors and the third and fourth inductors is LL, each of the inductance of the fifth inductor and the inductance of the sixth inductor in the series circuit is IL, the capacitance of the first capacitor in the series circuit is dC, and each of the capacitance of the second capacitor and the capacitance of the third capacitor is sC, preferably, the inductance of the first and second inductors and the inductance of the third and fourth inductors is LL/8 and has the same value, and the following conditions are satisfied.

$$0 < IL/2 < LL/8 \quad \dots (A\text{-}4)$$

$$0 < sC < dC/2 \dots (B\text{-}4)$$

A noise suppression circuit according to a third aspect of the invention is a circuit suppressing common-mode noise transmitted in the same phase on first and second conductive lines, including: first and second inductors inserted in series in the first conductive line and electromagnetically coupled to each other; a first series circuit in which a third inductor and a first capacitor are connected in series, the third inductor side of the first series circuit is connected between the first and second inductors, and the first capacitor side of the first series circuit is grounded; a second capacitor whose one end is connected to the first conductive line on one side of a series inductor section configured of the first and the second inductors and whose other end is connected between the third inductor and the first capacitor in the first series circuit, fourth and fifth inductors inserted in series in the second conductive line, magnetically coupled to the first and second inductors, and electromagnetically coupled to each other; a second series circuit in which a sixth inductor and a third capacitor are connected in series, the sixth inductor side of the second series circuit is connected between the fourth and fifth inductors, and the third capacitor side of the second series circuit is grounded; and a fourth capacitor whose one end is connected to the second conductive line on one side of a series inductor section configured of the forth and the fifth inductors, the one side corresponding to a connection point of the second capacitor to the first conductive line, and whose other end is connected between the sixth inductor and the third capacitor in the second series circuit.

The noise suppression circuit according to the third aspect of the invention is a noise suppression circuit suppressing common-mode noise. By providing a second capacitor whose one end is connected to the first conductive line on the first inductor side or the second inductor side and whose other end is connected between the third inductor and the first capacitor in the first series circuit, and a fourth capacitor whose one end is connected to the second conductive line and whose other end is connected between the sixth inductor and the third capacitor in the second series circuit, disturbance of the inherent operation of the noise suppression circuit by stray capacitance generated in parallel with the first and second inductors and stray capacitance generated in parallel with the fourth and fifth inductors and deterioration of the high frequency characteristic due to fluctuations in the input/output impedance is suppressed. For example, also in the case where the impedance becomes high and the action of the inductance components of the first and second inductors becomes weaker, a part of current flowing in the first and second inductors passes through the second capacitor, thereby preventing deterioration in the characteristic. Similarly, also in the case where the action of the inductance components of the fourth and fifth inductors becomes weaker, a part of current flowing in the fourth and fifth inductors passes through the fourth capacitor, thereby preventing deterioration in the characteristic. Thus, even if the impedance fluctuates on the input side or the output side, the common-mode noise can be suppressed excellently in a wide frequency range.

This case is preferable since an excellent characteristic adapted to all of impedances is obtained by adjusting the inductance IL of the third and sixth inductors in the series circuit and the capacitance sC of the second and fourth capacitors so as to satisfy the following conditions. Specifically, when each of the overall inductance of a combination of the first and second inductors and the overall inductance of a combination of the fourth and fifth inductors is LL, each of the inductance of the third inductor in the first series circuit and the inductance of the sixth inductor in the second series circuit is IL, each of the capacitance of the first capacitor in the first series circuit and the capacitance of the third capacitor in the second series circuit is dC, and each of the capacitance of the second capacitor and the capacitance of the fourth capacitor is sC, preferably, the inductance of the first and second inductors and the inductance of the fourth and fifth inductors is LL/4 and has the same value, and the following conditions are satisfied.

$$0 < IL < LL/4 \ldots (A\text{-}5)$$

$$0 < sC < dC \quad \ldots (B\text{-}5)$$

Examples of the first and second conductive lines in the noise suppression circuits according to the aspects are conductive lines in a single-phase two-wire power line and two lines out of three lines in a single-phase three-wire power line currently often used for power supply.

In the noise suppression circuits according to the aspects of the invention, a capacitor is connected to a first or second conductive line and a series circuit, and a new signal path extending from the first or second conductive line to the series circuit via the capacitor is formed. Consequently, even if the impedance fluctuates on the input side of the output side, deterioration in the signal characteristic due to the fluctuations is suppressed, and noise can be excellently suppressed in a wide frequency range.

Brief Description of Drawings

Fig. 1A is a circuit diagram showing a first configuration example of a noise suppression circuit according to a first embodiment of the invention.

Fig. 1B is a circuit diagram showing a second configuration example of the noise suppression circuit according to the first embodiment of the invention.

Fig. 2 is a diagram showing an actual configuration example of first and second inductors.

Fig. 3 is a circuit diagram for explaining the operation of the noise suppression circuit according to the first embodiment of the invention.

Fig. 4 is a circuit diagram for explaining the action of a second capacitor in the noise suppression circuit according to the first embodiment of the invention.

Fig. 5 is a diagram showing a circuit configuration used for simulation for obtaining characteristics of the noise suppression circuit according to the first embodiment of the invention.

Fig. 6 is a characteristic diagram showing the result of simulation of an attenuation characteristic on the low frequency side in the case where inductance IL is adjusted in the noise suppression circuit according to the first embodiment of the invention.

Fig. 7 is a characteristic diagram showing the result of simulation of an attenuation characteristic on the low frequency side in the case where capacitance sC is adjusted in the noise suppression circuit according to the first embodiment of the invention.

Fig. 8 is a characteristic diagram showing a state where an attenuation characteristic on the high frequency side is improved by the value of the capacitance sC in the noise suppression circuit according to the first embodiment of the invention.

Fig. 9 is a characteristic diagram showing the result of simulation of an attenuation characteristic in the case where both of an impedance Zi on the input side and an impedance Zo on the output side is set to 50Ω in the noise suppression circuit according to the first embodiment of the invention.

Fig. 10 is a characteristic diagram showing the result of simulation of an attenuation characteristic in the case where both of the impedance Zi on the input side and the impedance Zo on the output side is set to 10mΩ in the noise suppression circuit according to the first embodiment of the invention.

Fig. 11 is a characteristic diagram showing the result of simulation of an attenuation characteristic in the case where both of the impedance Zi on the input side and the impedance Zo on the output side is set to 1kΩ in the noise suppression circuit according to the first embodiment of the invention.

Fig. 12 is a characteristic diagram showing the result of simulation of an attenuation characteristic in the case where the impedance Zo on the output side is set to 50Ω and the impedance Zi on the input side is set to 10 mΩ in the noise suppression circuit according to the first embodiment of the invention.

Fig. 13 is a characteristic diagram showing the result of simulation of an attenuation characteristic in the case where the impedance Zo on the output side is set to 50Ω and the impedance Zi on the input side is set to 1 kΩ in the noise suppression circuit according to the first embodiment of the invention.

Fig. 14 is a characteristic diagram showing the result of simulation of an attenuation characteristic in the case where the impedance Zi on the input side is set to 50Ω and the impedance Zo on the output side is set to 10 mΩ in the noise suppression circuit according to the first embodiment of the invention.

Fig. 15 is a characteristic diagram showing the result of simulation of an attenuation characteristic in the case where the impedance Zi on the input side is set to 50Ω and the impedance Zo on the output side is set to 1 kΩ in the noise suppression circuit according to the first embodiment of the invention.

Fig. 16 is a diagram showing a first modification of the noise suppression circuit according to the first embodiment of the invention.

Fig. 17 is a circuit diagram for explaining a circuit value of the noise suppression circuit of the first modification.

Fig. 18 is a circuit diagram showing a second modification of the noise suppression circuit according to the first embodiment of the invention.

Fig. 19 is a diagram for explaining a circuit value of the noise suppression circuit of the second modification.

Fig. 20 is a circuit diagram showing a first configuration example of the noise suppression circuit according to a second embodiment of the invention.

Fig. 21 is a diagram for explaining a circuit value of the noise suppression circuit of Fig. 20.

Fig. 22 is a circuit diagram showing a second configuration example of the noise suppression circuit according to the second embodiment of the invention.

Fig. 23 is a diagram for explaining a circuit value of the noise suppression circuit of Fig. 22.

Fig. 24 is a circuit diagram showing a configuration example of a noise suppression circuit according to a third embodiment of the invention.

Fig. 25 is a diagram for explaining a circuit value of the noise suppression circuit of Fig. 24.

Fig. 26 is a characteristic diagram showing comparison of attenuation characteristics of the noise suppression circuits according to the first to third embodiments of the invention.

Fig. 27 is a diagram showing the configuration of a first circuit used for comparison of the attenuation characteristic in Fig. 26.

Fig. 28 is a diagram showing the configuration of a second circuit used for comparison of the attenuation characteristic in Fig. 26.

Fig. 29 is a diagram showing the configuration of a third circuit used for comparison of the attenuation characteristics in Fig. 26.

Fig. 30 is a diagram showing the configuration of a fourth circuit used for comparison of the attenuation characteristics in Fig. 26.

Fig. 31 is a diagram showing the configuration of a fifth circuit used for comparison of the attenuation characteristics in Fig. 26.

Fig. 32 is a diagram showing the configuration of a sixth circuit used for comparison of the attenuation characteristics in Fig. 26.

Fig. 33 is a circuit diagram showing a configuration example of a conventional noise suppression circuit.

Fig. 34 is a circuit diagram for explaining problems of the conventional noise suppression circuit.

Best Mode for Carrying Out the Invention

Embodiments of the present invention will be described in detail hereinbelow with reference to the drawings.

First Embodiment

First, a noise suppression circuit according to a first embodiment of the invention will be described. The noise suppression circuit according to the first embodiment is an unbalanced circuit for suppressing normal-mode noise propagated through two conductive lines and causing the potential difference between the conductive lines.

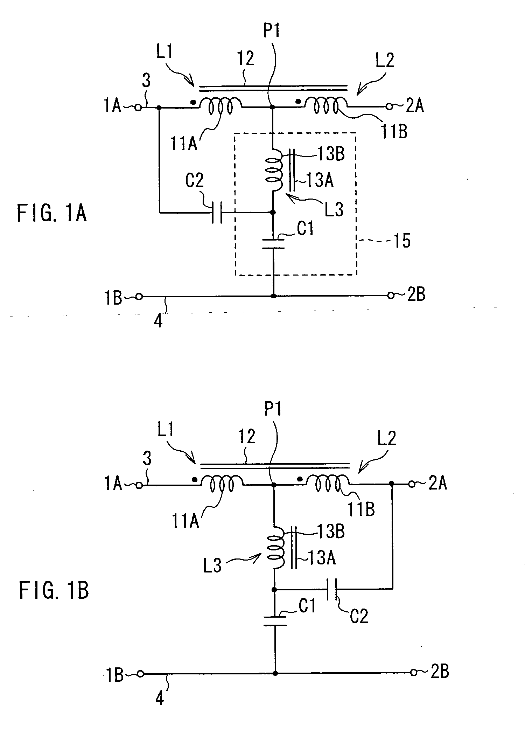

Fig. 1A shows a first configuration example of a noise suppression circuit according to the embodiment. The noise suppression circuit has a pair of terminals 1A and 1B, another pair of terminals 2A and 2B, a first conductive line 3 connecting the terminals 1A and 2A, and a second conductive line 4 connecting the terminals 1B and 2B. The noise suppression circuit further includes first and second inductors L1 and L2 inserted in series in the first conductive line 3. The noise suppression circuit also includes a first series circuit 15 in which a third inductor L3 and a first capacitor C1 are connected in series, the third inductor L3 side is connected between the first and second inductors L1 and L2, and the first capacitor C1 side is connected to the second conductive line 4. The noise suppression circuit further includes a second capacitor C2 whose one end is connected to the first conductive line 3 on the first inductor L1 side and whose other end is connected between the third inductor L3 and the first capacitor C1 in the series circuit 15.

Like a second circuit example shown in Fig. 1B, one end of the second capacitor C2 may be connected to the second inductor L2 side, not the first inductor L1 side. However, it is preferable to connect one end of the second capacitor C2 to the signal input side for the reason that when the impedance at the noise source becomes low, the circuit functions satisfactorily.

In the series circuit 15, the third inductor L3 has a winding 13A wound around a core 13B. The winding direction of the winding 13A and the polarity direction in the third inductor L3 are not limited. In the series circuit 15, the first capacitor C1 functions as a high-pass filter for passing a normal-mode signal having a frequency equal to or higher than a predetermined value.

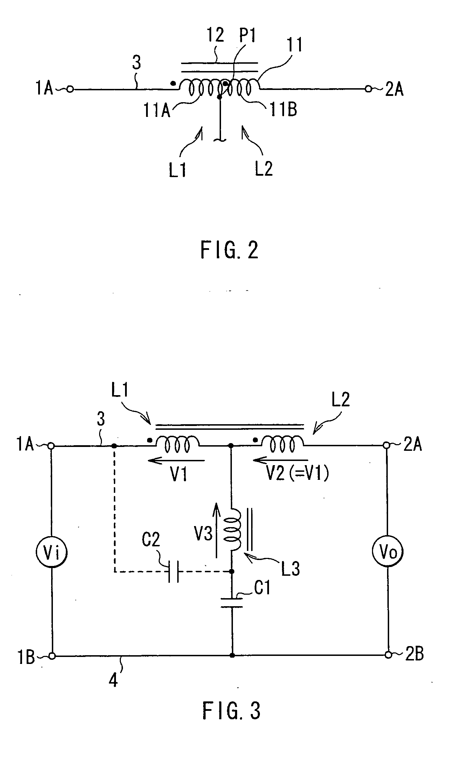

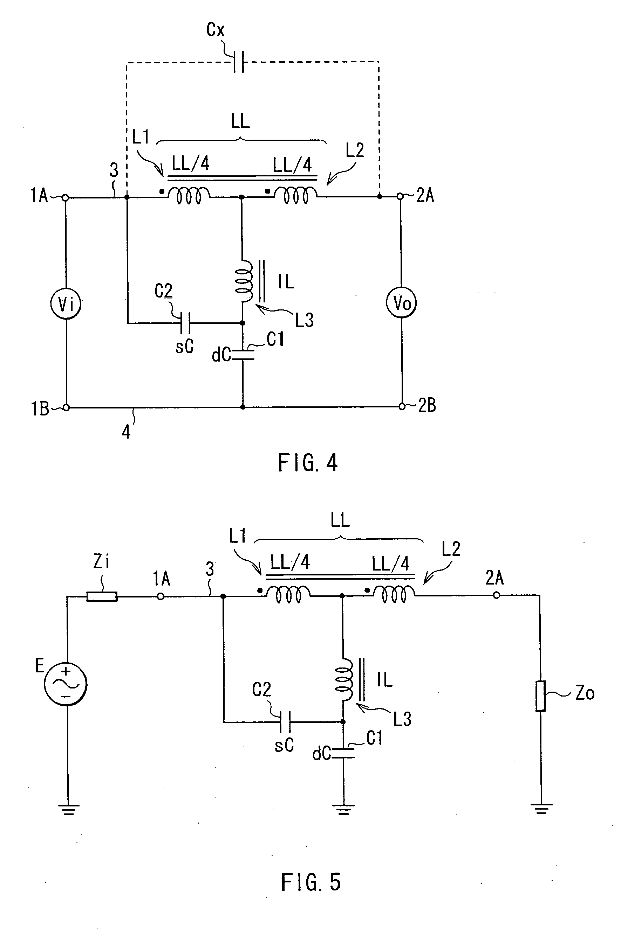

The first and second inductors L1 and L2 are electromagnetically coupled to each other and have the same polarity. The first inductor L1 has a winding 11A wound around a first part in a core 12. The second inductor L2 has a winding 11B wound around a second part in the core 12 in the same direction as that of the winding 11A. Although the first and second inductors L1 and L2 may be formed by the different windings 11A and 11B, respectively, they can be also formed by a single winding 11 as shown in Fig. 2. In Fig. 4, the winding 11 is wound around the core 12. In Fig. 4, the circuits other than the first and second inductors L1 and L2 are not shown.

In the case of forming the first and second inductors L1 and L2 by a single winding, for example, it is sufficient to provide a connection point P1 in some midpoint of the single winding 11 as shown in Fig. 2 and set a portion from one end of the winding 11 to the connection point as the winding 11A of the first inductor L1. Similarly, it is also sufficient to form the second inductor L2 by using a portion from the other end of the winding 11 to the connection point as the winding 11B. One end of the series circuit 15 is connected to the connection point P1.

Preferably, the inductance of the first and second inductors L1 and L2 has the same value. In the case of forming the first and second inductors L1 and L2 by the single winding 11, for example, by providing the connection point P1 at the middle point of the single winding 11, the inductance can be made equal to each other.

The action of the noise suppression circuit according to the embodiment will now be described. First, with reference to Fig. 3, ideal operation of a circuit section excluding the second capacitor C2, that is, a basic circuit section for noise suppression will be described. It is assumed that the inductance of the first and second inductors L1 and L2 has the same value, the coupling coefficient is 1, and impedance of the first capacitor C1 is so low as to be ignorable. In this case, when a voltage Vi in the normal mode is applied across the terminals 1A and 1B, the voltage Vi is divided by the first inductor L1 and the third inductor L3 in the series circuit 15, so that a predetermined voltage V1 develops across the first inductor L1, and a predetermined voltage V3 develops across the third inductor L3. Each of the arrows in the diagram shows that the potential at the pointing side is higher. Since the first inductor L1 and the second inductor L2 are electromagnetically coupled to each other, the same voltage V2 as the voltage V1 is generated across the second inductor L2 in accordance with the voltage V1 generated across the first inductor L1. As a result, the voltage Vo between the terminals 2A and 2B becomes lower than the voltage Vi applied across the terminals 1A and 1B. On the other hand, also in the case where a voltage in the normal mode is applied between the terminals 2A and 2B, in a manner similar to the above, the voltage between the terminals 1A and 1B becomes lower than the voltage applied between the terminals 2A and 2B. In such a manner, ideally, normal-mode noise can be suppressed in both of the case where normal mode noise applied to the terminals 1A and 1B and the case where normal mode noise applied to the terminals 2A and 2B.

Next, referring to Fig. 4, the action when the second capacitor C2 is added will be described. Under actual circuit conditions, the stray capacitance Cx exists in parallel with the first and second inductors L1 and L2 as shown in Fig. 4, and a through path is formed by the stray capacitance Cx. It disturbs the above-described ideal noise suppressing operation. In the case where input and output impedances fluctuate with time and, particularly, the impedance becomes high, the action of the inductance components of the first and second inductors L1 and L2 becomes weaker and it disturbs the noise suppressing operation particularly in a high frequency range.

By the second capacitor C2, the problems are solved and excellent noise suppressing operation is realized. By providing the second capacitor C2, a new signal path extending from the first conductive line 3 to the series circuit 15 side is formed. For example, when the impedance becomes high and the action of the inductance components of the first and second inductors L1 and L2 becomes weak, a part of current flowing from the terminal 1A side to the terminal 2A side via the first and second inductors L1 and L2 passes through the second capacitor C2. Consequently, the current flowing to the terminal 2A side is reduced, and deterioration in the characteristics caused by weakening of the action of the inductance components is prevented.

By adjusting the inductance IL of the third inductor L3 in the series circuit 15 and the capacitance sC of the second capacitor C2 so as to satisfy the following conditions, excellent characteristics adapted to all of impedances are obtained. Specifically, when the overall inductance of the combination of the first and second inductors L1 and L2 is LL, the inductance of the third inductor L3 in the first series circuit 15 is IL, the capacitance of the first capacitor L1 in the first series circuit 15 is dC, and the capacitance of the second capacitor C2 is sC, preferably, the inductance of the first and second inductors L1 and L2 has the same value and is LL/4, and the following conditions are satisfied.

$$0 < IL < LL/4 \quad \dots \quad (A\text{-}1)$$

$$0 < sC < dC \quad \dots \quad (B\text{-}1)$$

As a concrete method of determining the values IL and sC, for example, from a state where initial circuit design values are set as sC=dC and IL = 0, sC is decreased to be smaller than dC, and the value IL is increased under the condition of IL<LL/4. By computing a value at which a desired characteristic is obtained while seeing a result of simulation of a signal characteristic at each of values, the values IL and sC can be determined. In the noise suppression circuit, a peak position appears in an attenuation characteristic of a signal as shown by a simulation to be described later. By adjusting the values of IL and sC, the peak position of the attenuation can be also adjusted.

Next, effects produced by providing the second capacitor C2 will be concretely described by using the result of the following simulation. In the following simulations, as shown in Fig. 5, the noise source E exists on the terminal 1A side, the impedance on the signal input side (the terminal 1A side) is written as Zi, and the impedance on the output side (the terminal 2A side) is written as Zo.

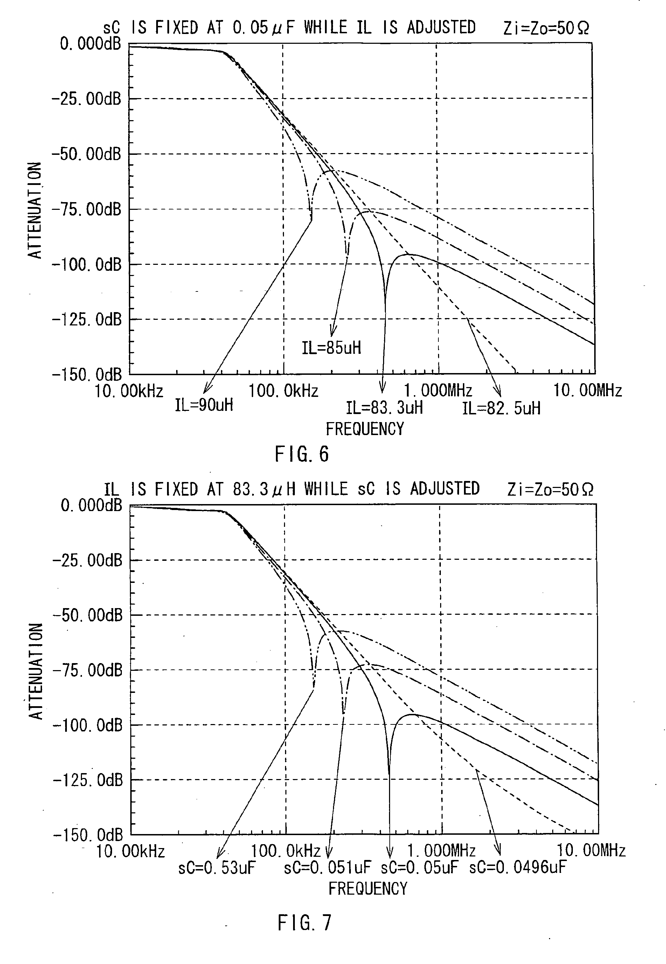

Fig. 6 shows a result of obtaining the frequency characteristics of an attenuation on the low frequency side of normal-mode noise by a simulation in the case where the value of the inductance IL is adjusted in the noise suppression circuit. More concretely, Fig. 6 shows the characteristics in the case where the value of the capacitance sC is fixed at 0.05 $\mu$F and the value of the inductance IL is changed as 90 $\mu$H, 85 $\mu$H, 83.3 $\mu$H, and 82.5 $\mu$H. The other circuit values are as shown below. In all of the cases, the above-described conditions of IL<LL/4 and sC<dC are satisfied.

Zi, Zo = 50$\Omega$

LL=1 mH

(the inductance of each of the first and second inductors L1 and L2 is set as LL/4 = 250 $\mu$H)

dC=0.1 $\mu$F

the coupling coefficient k of the first and second inductors L1 and L2 = 0.995

Fig. 7 shows a result of obtaining the frequency characteristics of an attenuation on the low frequency side of normal-mode noise by a simulation in the case where the value of the capacitance sC is adjusted in the noise suppression circuit. More concretely, Fig. 7 shows the characteristics in the case where the value of the inductance IL is fixed at 83.3 $\mu$H and the value of the capacitance sC is changed as 0.053 $\mu$F, 0.051 $\mu$F, 0.05 $\mu$F, and 0.0496 $\mu$F. The other circuit values are similar to those of the simulation of Fig. 6. In all of the cases, the above-described conditions of IL<LL/4 and sC<dC are satisfied.

It is understood from the simulation result of Fig. 6 that as the value of the inductance IL increases, the attenuation peak position shifts to the low frequency side. It is also understood from the simulation result of Fig. 7 that, similarly, as the value of the capacitance sC increases, the attenuation peak position shifts to the low frequency side.

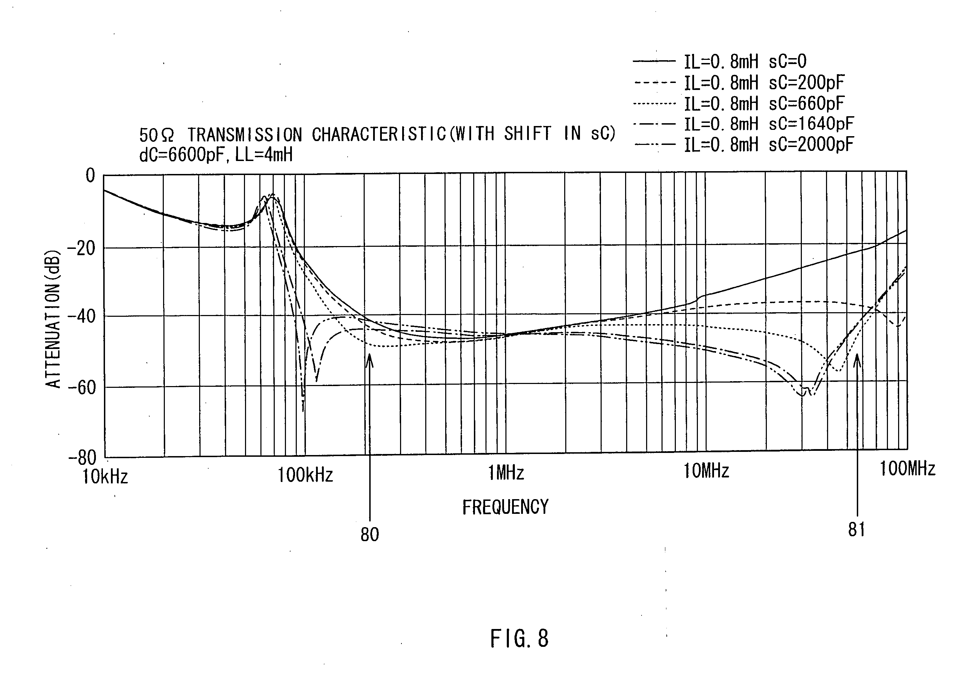

Fig. 8 shows a result of obtaining the frequency characteristics of an attenuation on a higher frequency side in the case where the value of the capacitance sC is adjusted. More concretely, Fig. 8 shows the characteristics in the case where the value of the inductance IL is fixed at 0.8 mH and the value of the capacitance sC is changed as 200 pF, 660 pF, 1640 pF, and 2000 pF. The other circuit values are as follows. In all of the cases, the above-described conditions of IL<LL/4 and sC<dC are satisfied. For comparison, the characteristics in the case where sC=0 were also obtained by a simulation.

Zi, Zo = 50$\Omega$

LL=4 mH

(the inductance of each of the first and second inductors L1 and L2 is set as LL/4 = 1 mH)

dC = 6600 pF

the coupling coefficient k of the first and second inductors L1 and L2 = 0.995

It is understood from the simulation result of Fig. 8 that, particularly, in the low frequency side (the portion shown by reference numeral 80), the attenuation peak position shifts to the low frequency side in accordance with the value of the capacitance sC. It is also understood that, particularly in the high frequency side (the portion shown by reference numeral 81), the attenuation characteristic improves in accordance with the value of the capacitance sC, and the attenuation characteristic in the high frequency range improves.

By considering the tendency of the attenuation characteristic as described above, the values of IL and sC at which a desired attenuation characteristic is obtained can be determined.

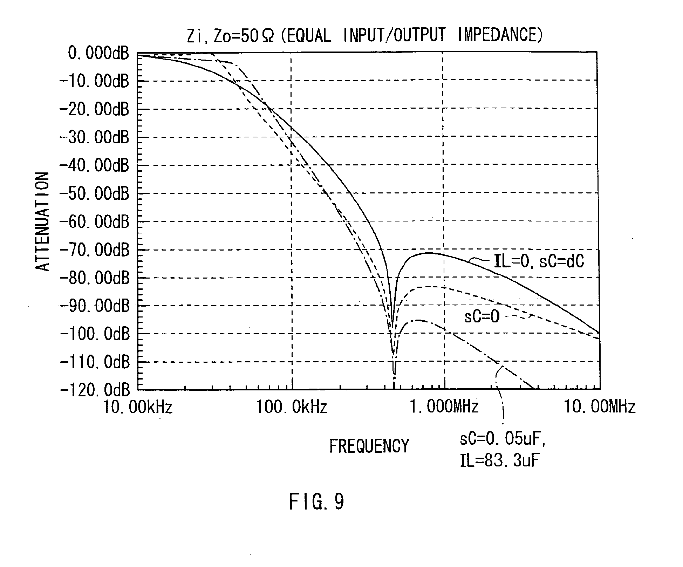

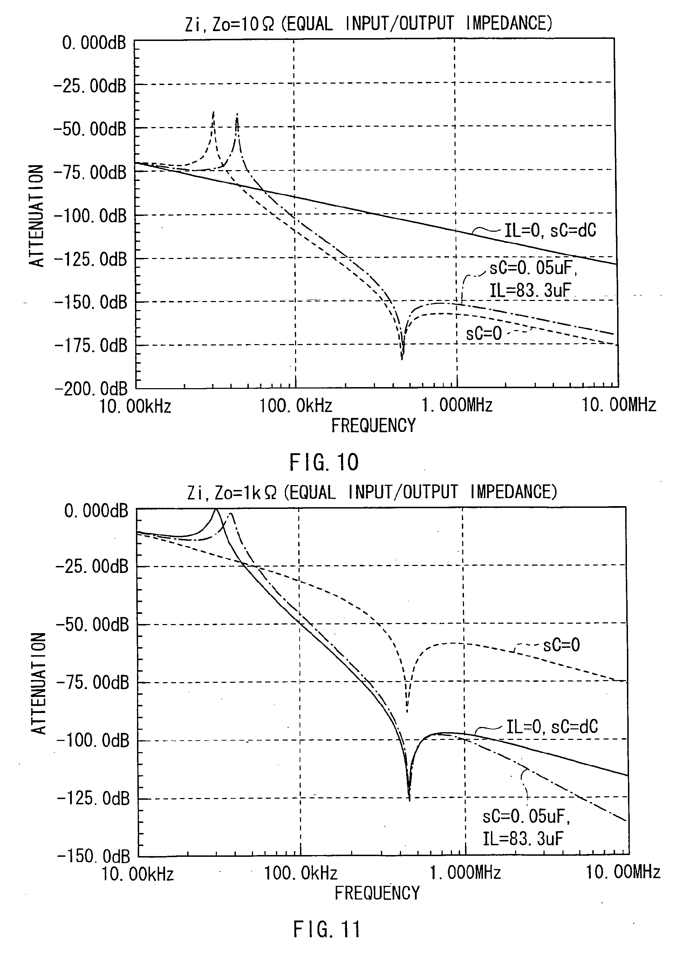

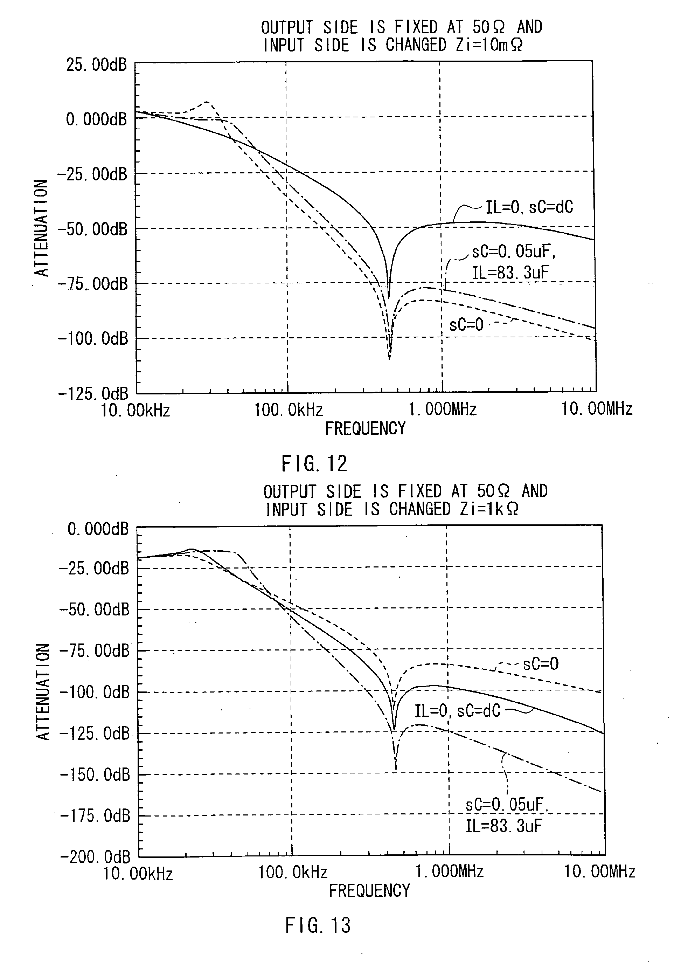

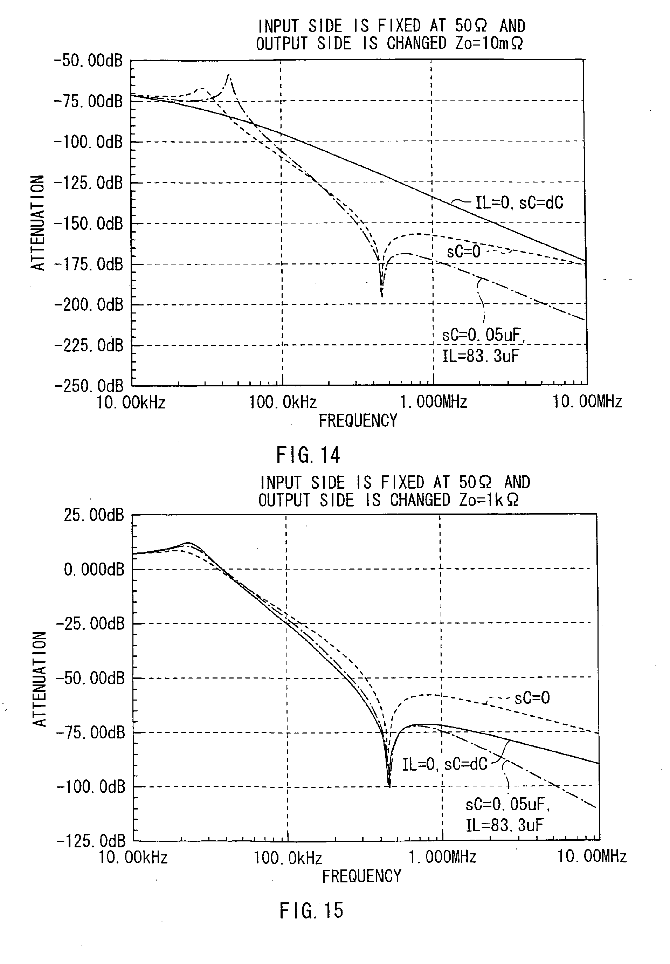

Figs. 9 to 15 show results of obtaining the frequency characteristic of the attenuation according to an impedance change by simulations. Figs. 9 to 11 show characteristics in the case where the impedance Zi on the input side and the impedance Zo on the output side are set to the same value. Specifically, Fig. 9 shows the attenuation characteristics in the case where Zi, Zo = 50$\Omega$. Fig. 10 shows the attenuation characteristics in the case of setting low impedance as Zi, Zo = 10 m$\Omega$. Fig. 11 shows the attenuation characteristics in the case of setting high impedance as Zi, Zo = 1 k$\Omega$. Figs. 12 and 13 show the attenuation characteristics in the case where the impedance on the output side is fixed at Zo=50$\Omega$ and the input-side impedance is changed as Zi=10 m$\Omega$, and 1 k$\Omega$. Figs. 14 and 15 show the attenuation characteristics in the case where the impedance on the input side is fixed at Zi=50$\Omega$ and the output-side impedance is changed as Zo=10 m$\Omega$ and 1 k$\Omega$.

The circuit values other than the impedance in the simulations of Figs. 9 to 15 are as follows.

LL=1mH

(the inductance of each of the first and second inductors L1 and L2 is set as LL/4 = 250 $\mu$H)

IL = 83.3 $\mu$H

dC = 0.1 $\mu$F

sC = 0.05 $\mu$F

the coupling coefficient k of the first and second inductors L1 and L2 = 0.995

Each of Figs. 9 to 15 also shows both the characteristic of circuits (sC=0, equivalent to the conventional circuit of Fig. 33) obtained by eliminating the second capacitor C2 from the circuit configuration of Fig. 1A and the characteristic of circuits (IL=0, sC=dC) of a circuit obtained by eliminating the third inductor L3 from the circuit configuration of Fig. 1A as comparative examples. The coupling coefficient k and the values of LL and dC in the circuits of the comparative examples are similar to the above.

It is understood from the simulation results of Figs. 9 to 15 that, although the attenuation characteristic may deteriorate depending on the values of the impedances Zi and Zo in the circuit of the comparative example, in the circuit of the embodiment, an excellent attenuation characteristic is obtained in all of impedance regions.

As described above, in the noise suppression circuit of the embodiment, the second capacitor C2 is connected to the first conductive line 3 and the series circuit 15, and a new signal path extending from the first conductive line 3 to the series circuit 15 is formed via the second capacitor C2. Consequently, even if the impedance fluctuates on the input side or output side, deterioration in the signal characteristic is suppressed, and normal-mode noise can be effectively suppressed in a wide frequency range.

Modifications of First Embodiment

First Modification

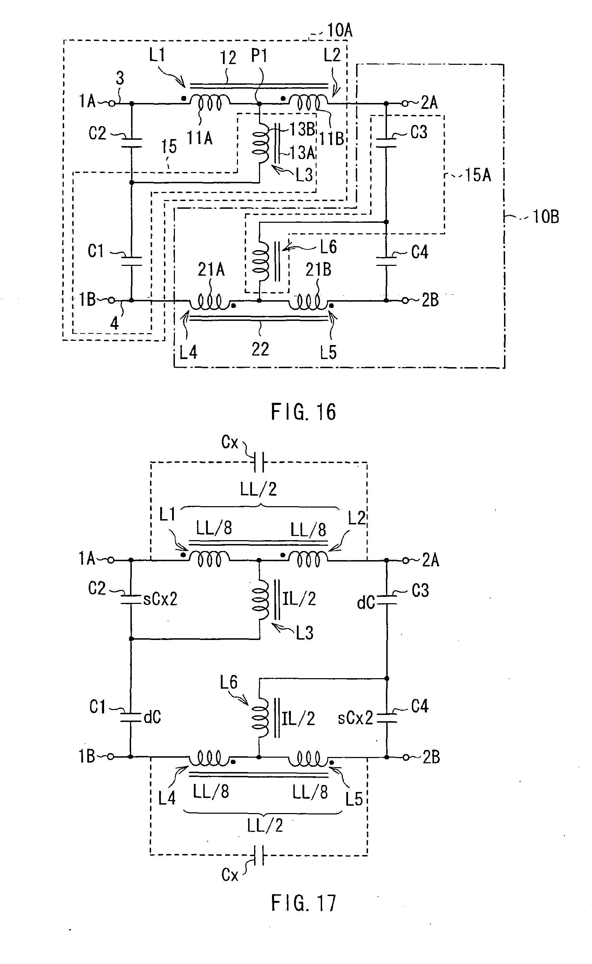

Fig. 16 shows a circuit configuration as a first modification of the noise suppression circuit of the first embodiment. The noise suppression circuit of the first modification is obtained by adding a second circuit part 10B to the circuit of Fig. 1A. The configuration of a first circuit part 10A is the same as that of the circuit of Fig. 1A. In the following description of the modification, the series circuit 15 in the first circuit part 10A will be called a first series circuit.

The added second circuit part 10B has fourth and fifth inductors L4 and L5 inserted in series in the second conductive line 4, having the same polarity, and electromagnetically coupled to each other. The second circuit part 10B also has a second series circuit 15A in which a sixth inductor L6 and a third capacitor C3 are connected in series, the sixth inductor L6 side is connected between the fourth and fifth inductors L4 and L5, and the third capacitor C3 side is connected to the first conductive line 3. The second circuit part 10B also has a fourth capacitor C4 whose one end is connected to the second conductive line 4 on the fifth inductor L5 side, and whose other end is connected between the sixth inductor L6 and the third capacitor C3 in the second series circuit 15A.

In the noise suppression circuit of the modification, the first capacitor C1 side of the first series circuit 15 is connected to the second conductive line 4 on the side different from the side to which one end of the fourth capacitor C4 is connected, which is either the fourth inductor L4 side or the fifth inductor L5 side. The third capacitor C3 side of the second series circuit 15A is connected to the first conductive line 3 on the side different from the side to which one end of the second capacitor C2 is connected, which is either the first inductor L1 side or the second inductor L2 side.

The fourth inductor L4 has a winding 21A wound around a first part in a core 22. The fifth inductor L5 has a winding 21B wound around a second part in the core 22 in the same direction as that of the winding 21A. Although the fourth and fifth inductors L4 and L5 may be formed by the separate windings 21A and 21B, respectively, they can be formed by a single winding like the first and second inductors L1 and L2.

The polarity directions of the first and second inductors L1 and L2 and the polarity directions of the fourth and fifth inductors L4 and L5 are not limited to those shown in the diagram. For example, the polarities of the fourth and fifth inductors L4 and L5 may be opposite to those shown in the diagrams.

In the circuit of the modification, preferably, all of the inductance of the first and second inductors L1 and L2 and the inductance of the fourth and fifth inductors L4 and L5 has the same value.

In the circuit of the modification, the added second circuit part 10B operates in a manner similar to the first circuit part 10A. By providing two circuits performing similar operation, normal-mode noise can be reduced more excellently as compared with the configuration using only the first circuit part 10A. In particular, in the circuit of the modification, the fourth capacitor C4 in the second circuit part 10B operates in a manner similar to the second capacitor C2 in the first circuit part 10A.

However, under the actual circuit conditions, as shown in Fig. 17, the stray capacitance Cx exists in parallel with the first and second inductors L1 and L2 and the fourth and fifth inductors L4 and L5. Through paths are formed by the stray capacitance Cx, and disturb the above-described ideal noise suppressing operation. In the case where input and output impedances fluctuate with time and, particularly, the impedance becomes high, the action of the inductance components of the first and second inductors L1 and L2 and the fourth and fifth inductors L4 and L5 becomes weaker and it disturbs the noise suppressing operation particularly in a high frequency range. By the second capacitor C2, the problems are solved and excellent noise suppressing operation is realized in the first circuit part 10. The action obtained by providing the second capacitor C2 is as described above. By the fourth capacitor C4, the problems are solved and excellent noise suppressing operation is realized in the second circuit part 10B.

By providing the fourth capacitor C4, a new signal path extending from the second conductive line 4 to the second series circuit 15A side is formed. For example, when the impedance becomes high and the action of the inductance components of the fourth and fifth inductors L1 and L2 becomes weak, a part of current flowing from the terminal 2B side to the terminal 1B side via the fourth and fifth inductors L4 and L5 passes through the fourth capacitor C4. Consequently, the current flowing to the terminal 1B side is reduced, and deterioration in the characteristics caused by weakening of the action of the inductance component is prevented.

By adjusting the inductance IL of the third inductor L3 in the first series circuit 15 and the sixth inductor L6 in the second series circuit 15A and the capacitance sC of the second and fourth capacitors C2 and C4 so as to satisfy the following conditions, excellent characteristics adapted to all of impedances are obtained. Specifically, as also shown in Fig. 17, when the sum of the overall inductance of a combination of the first and second inductors L1 and L2 and the overall inductance of a combination of the fourth and fifth inductors L4 and L5 is LL, each of the inductance of the third inductor L3 in the first series circuit 15 and the inductance of the sixth inductor L6 in the second series circuit 15A is IL, each of the capacitance of the first capacitor C1 in the first series circuit 15 and the capacitance of the third capacitor C3 in the second series circuit 15A is dC, and each of the capacitance of the second capacitor C2 and the capacitance of the fourth capacitor C4 is sC, preferably, the inductance of the first and second inductors L1 and L2 and the inductance of the fourth and fifth inductors L4 and L5 is LL/8 and has the same value, and the following conditions are satisfied.

$$0 < IL/2 < LL/8 \quad \ldots (A\text{-}2)$$

$$0 < sC < dC \quad \ldots (B\text{-}2)$$

Fig. 17 shows the values of sC and IL for obtaining excellent characteristics using the values of sC and IL in the circuit of Fig. 1A as a reference. As shown in the diagram, it is preferable to set the value of sC to be twice as large as that of sC in the circuit of Fig. 1A and to set the value of IL to be the half of the value of IL in the circuit of Fig. 1A.

Second Modification

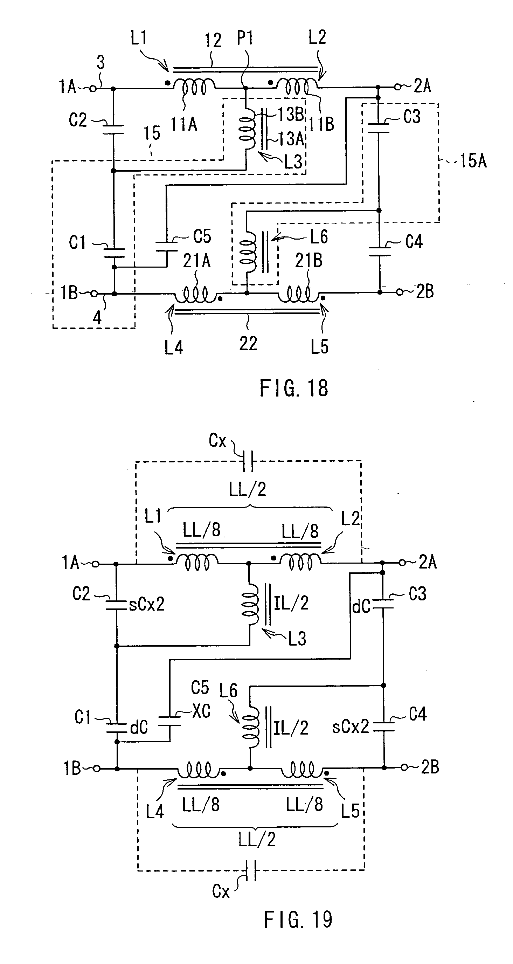

Fig. 18 shows a circuit configuration of a second modification of the noise suppression circuit of the first embodiment. The noise suppression circuit of the second modification is obtained by adding a fifth capacitor C5 to the circuit of the second modification shown in Fig. 16. The fifth capacitor C5 functions as a so-called X capacitor. One end of the fifth capacitor C5 is connected to the first capacitor C1 side of the first series circuit 15 or the side to which the first series circuit 15 is connected in the second conductive line 4. The other end of the fifth capacitor C5 is connected to the third capacitor C3 side of the second series circuit 15A or the side to which the second series circuit 15A is connected in the first conductive line 3. By providing the X capacitor, the normal-mode noise can be reduced more excellently as compared with the circuit of the second modification shown in Fig. 16.

Preferable circuit values in the noise suppression circuit of the second modification are similar to those of the circuit of the second modification shown in Fig. 16. That is, as shown in Fig. 19, it is preferable to set the value of sC to be twice as large as that of sC in the circuit of Fig. 1A and to set the value of IL to be the half of the value of IL in the circuit of Fig. 1A.

Second Embodiment

A noise suppression circuit according to a second embodiment of the invention will now be described.

The noise suppression circuit according to the second embodiment is a balanced circuit for suppressing normal-mode noise propagating through two conductive lines and causing a potential difference between the conductive lines.

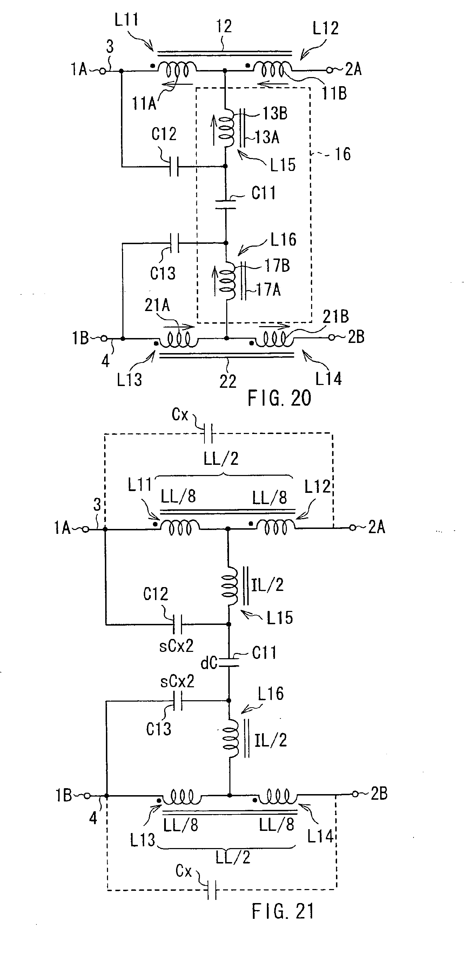

Fig. 20 shows a first configuration example of the noise suppression circuit according to the second embodiment of the invention. The same reference numerals are designated to components substantially the same as those of the noise suppression circuit of the first embodiment. The noise suppression circuit has first and second inductors L11 and L12 inserted in series in the first conductive line 3, having the same polarity, and electromagnetically coupled to each other, and third and fourth inductors L13 and L14 inserted in series in the second conductive line 4, having the same polarity, and electromagnetically coupled to each other. The noise suppression circuit also has a series circuit 16 including a fifth inductor L15, a first capacitor C11, and a sixth inductor L16. In the series circuit 16, one end of the fifth inductor L15 is connected between the first and second inductors L11 and L12. One end of the first capacitor C11 is connected to the other end of the fifth inductor L15. One end of the sixth inductor L16 is connected to the other end of the first capacitor C11, and the other end is connected between the third and fourth inductors L13 and L14.

The noise suppression circuit further includes a second capacitor C12 whose one end is connected to the first conductive line 3 on the first inductor L11 side and whose other end is connected between the fifth inductor L15 and the first capacitor C11 in the series circuit 16. The noise suppression circuit further includes a third capacitor C3 whose one end is connected to the second conductive line 4 on the third inductor L13 side and whose other end is connected between the sixth inductor and the first capacitor in the series circuit 16.

Although not shown, one end of the second capacitor C12 may be connected to the second inductor L12 side, not the first inductor L11 side, and one end of the third capacitor C13 may be connected to the fourth inductor L14 side, not the third inductor L13 side. Specifically, one end of the second capacitor C12 and one end of the third capacitor C13 may be connected to the same side so as to correspond to each other, which is the signal input side or the output side. However, it is preferable to connect one end of each of the second and third capacitors C12 and C13 to the signal input side for the reason that the circuit functions excellent particularly when the impedance becomes low at the noise source.

In the series circuit 16, the fifth inductor L15 has a winding 13A wound around a core 13B, and the sixth inductor L16 has a winding 17A wound around a core 17B. In the series circuit 16, the first capacitor C11 functions as a high-pass filter for passing a normal-mode signal having a frequency equal to or higher than a predetermined value. The winding directions of the windings 13A and 17A and the polarity directions in the fifth and sixth inductors L15 and L16 are not limited.

The first inductor L11 has a winding 11A wound around a first part in a core 12 like the first inductor L1 in the circuit of Fig. 1A. The second inductor L12 has a winding 11B wound around a second part in the core 12 in the same direction as that of the winding 11A like the second inductor L2 in the circuit of Fig. 1A. Although the first and second inductors L11 and L12 may be formed by the different windings 11A and 11B, respectively, they may be formed by a single winding like the first and second inductors L1 and L2 in the circuit of Fig. 1A.

The third inductor L13 has a winding 21A wound around a first part in a core 22. The fourth inductor L14 has a winding 21B wound around a second part in the core 22 in the same direction as that of the winding 21A. Although the third and fourth inductors L13 and L14 may be formed by the different windings 21A and 21B, respectively, they may be formed by a single winding like the first and second inductors L11 and L12.

The polarity directions of the first and second inductors L11 and L12 and the polarity directions of the third and fourth inductors L13 and L14 are not limited to those shown in the diagram. For example, the polarities of the third and fourth inductors L13 and L14 may be opposite to those shown in the diagrams.

In the circuit, preferably, all of the inductance of the first and second inductors L11 and L12 and the inductance of the third and fourth inductors L13 and L14 has the same value.

The action of the noise suppression circuit according to the embodiment will now be described. First, ideal operation of a circuit section excluding the second and third capacitors C12 and C13, that is, a basic circuit section for noise suppression will be described. It is assumed that the inductance of the first and second inductors L11 and L12 has the same value, and the coupling coefficient is 1. The inductance of the third and fourth inductors L13 and L14 also has the same value, and the coupling coefficient is 1. The impedance of the first capacitor C11 in the series circuit 16 is so low as to be ignorable.

In a manner similar to the case of Fig. 3, when a voltage Vi in the normal mode is applied across the terminals 1A and 1B, the voltage Vi is divided by the first inductor L11, the series circuit 16, and the third inductor L13, so that a predetermined voltage develops across each of the first inductor L11, the series circuit 16, and the third inductor L13. Each of the arrows in the diagram shows that the potential at the pointing side is higher. Since the first inductor L11 and the twelfth inductor L12 are electromagnetically coupled to each other, a predetermined voltage is generated across the second inductor L12 in accordance with the voltage generated across the first inductor L11. Similarly, since the third inductor L13 and the fourth inductor L14 are electromagnetically coupled to each other, a predetermined voltage is generated across the fourth inductor L14 in accordance with the voltage generated across the third inductor L13. As a result, the voltage between an end of the second inductor L12 and an end of the fourth inductor L14, that is, the voltage Vo between the terminals 2A and 2B becomes lower than the voltage Vi applied between an end of the first inductor L11 and an end of the third inductor L13.

Also in the case where a voltage in the normal mode is applied between the terminals 2A and 2B, in a manner similar to the above description, the voltage between the terminals 1A and 1B becomes lower than the voltage applied between the terminals 2A and 2B. In such a manner, ideally, normal mode noise can be suppressed in both of the case where normal mode noise applied to the terminals 1A and 1B and the case where normal mode noise applied to the terminals 2A and 2B.

However, under actual circuit conditions, the stray capacitance Cx exists in parallel with each of the first and second inductors L11 and L12 and the third and fourth inductors L13 and L14 as shown in Fig. 21. Through paths are formed by the stray capacitance Cx, and it disturbs the above-described ideal noise suppressing operation. In the case where input and output impedances fluctuate with time and, particularly, the impedance becomes high, the action of the inductance components of the first and second inductors L11 and L12 and the third and fourth inductors L13 and L14 becomes weaker and it disturbs the noise suppressing operation particularly in a high frequency range. By the second and third capacitors C12 and C13, the problems are solved and excellent noise suppressing operation is realized. For example, by providing the second capacitor C12, a new signal path extending from the first conductive line 3 to the series circuit 16 side is formed. For example, when the impedance becomes high and the action of the inductance components of the first and second inductors L11 and L12 becomes weak, a part of current flowing from the terminal 1A side to the terminal 2A side via the first and second inductors L11 and L12 passes through the second capacitor C12. Consequently, the current flowing to the terminal 2A side is reduced, and deterioration in the characteristics caused by weakening of the action of the inductance component is prevented. The third capacitor C13 also similarly acts on the third and fourth inductors L13 and L14.

By adjusting the inductance IL of the fifth and sixth inductors L15 and L16 in the series circuit 16 and the capacitance sC of the second and third capacitors C12 and C13 so as to satisfy the following conditions, excellent characteristics adapted to all of impedances are obtained. Specifically, as also shown in Fig. 21, when the sum of the overall inductance of a combination of the first and second inductors L11 and L12 and the overall inductance of a combination of the third and fourth inductors L13 and L14 is LL, each of the inductance of the fifth inductor L15 in the series circuit 16 and the inductance of the sixth inductor L16 in the series circuit 16 is IL, the capacitance of the first capacitor C11 in the series circuit 16 is dC, and each of the capacitance of the second capacitor C2 and the capacitance of the third capacitor C3 is sC, preferably, the inductance of the first and second inductors L11 and L12 and the inductance of the third and fourth inductors L13 and L14 is LL/8 and has the same value, and the following conditions are satisfied.

$$0 < IL/2 < LL/8 \qquad \dots (A\text{-}3)$$

$$0 < sC < dC/2 \dots (B\text{-}3)$$

Fig. 21 shows the values of sC and IL for obtaining excellent characteristics using the values of sC and IL in the circuit of Fig. 1A as a reference. As shown in the diagram, it is preferable to set the value of sC to be twice as large as that of sC in the circuit of Fig. 1A and to set the value of IL to be the half of the value of IL in the circuit of Fig. 1A.

As described above, in the noise suppression circuit of the second embodiment, the inductor is inserted in each of the first and second conductive lines 3 and 4 so that the impedance characteristics of the first and second conductive lines 3 and 4 are balanced. Therefore, increase in the strength of radiation electric fields from the first and second conductive lines 3 and 4 can be suppressed and occurrence of radiation noise can be suppressed. In addition, the second capacitor C12 is connected to the first conductive line 3 and the series circuit 16, and the third capacitor C13 is connected to the second conductive line 4 and the series circuit 16. New signal paths extending from the first and second conductive lines 3 and 4 to the series circuit 16 are formed via the second and third capacitors C12 and C13, respectively. Consequently, even if the impedance fluctuates on the input side or the output side, deterioration in the signal characteristic is suppressed, and normal-mode noise can be effectively suppressed in a wide frequency range. The other configurations, actions, and effects of the second embodiment are similar to those of the first embodiment.

Modification of Second Embodiment

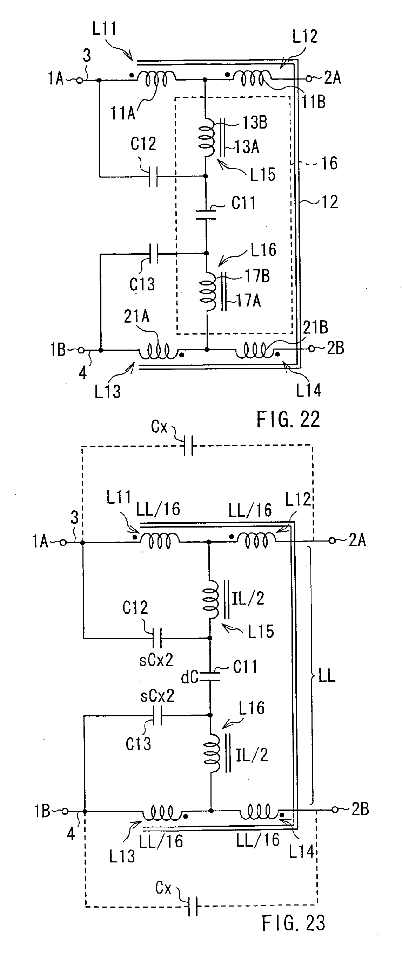

Fig. 22 shows the circuit configuration of a modification of the noise suppression circuit of the second embodiment. The noise suppression circuit of the modification has a configuration that the first and second inductors L11 and L12 and the third and fourth inductors L13 and L14 have the same polarity and are electromagnetically coupled to each other in the circuit shown in Fig. 20. Specifically, all of the windings 11A, 11B, 21A, and 21B are wound around the single core 12 in the same direction, thereby forming the first and second inductors L11 and L12 and the third and fourth inductors L13 and L14. In this case, the coupling is performed so as to increase a magnetic field generated in the first and second inductors L11 and L12 when a normal-mode signal is passed. With the configuration, the impedance of normal-mode noise can be increased, and noise can be suppressed more effectively. Further, in comparison with the circuit shown in Fig. 20, the core 12 of the first and second inductors L11 and L12 and the core 22 of the third and fourth inductors L13 and L14 can be made common. Thus, it can contribute to miniaturization, and a coil having small inductance can be used as the first and second inductors L11 and L12, the third and fourth inductors L13 and L14, and the fifth and sixth inductors L15 and L16.

By adjusting the inductance IL of the fifth and sixth inductors L15 and L16 in the series circuit 16 and the capacitance sC of the second and third capacitors C12 and C13 so as to satisfy the following conditions, excellent characteristics adapted to all of impedances are obtained. Specifically, as also shown in Fig. 23, when the overall inductance of the first and second inductors L11 and L12 and the third and fourth inductors L13 and L14 is LL, each of the inductance of the fifth and sixth inductors L15 and L16 in the series circuit 16 is IL, the capacitance of the first capacitor C11 in the series circuit is dC, and each of the capacitance of the second capacitor C12 and the capacitance of the third capacitor C13 is sC, preferably, the inductance of the first and second inductors L11 and L12 and the inductance of the third and fourth inductors L13 and L14 is LL/8 and has the same value, and the following conditions are satisfied.

$$0 < IL/2 < LL/8 \qquad \dots (A\text{-}4)$$

$$0 < sC < dC/2 \dots (B\text{-}4)$$

Fig. 23 shows the values of sC and IL for obtaining excellent characteristics using the values of sC and IL in the circuit of Fig. 1A as a reference. As shown in the diagram, it is preferable to set the value of sC to be twice as large as that of sC in the circuit of Fig. 1A and to set the value of IL to be the half of the value of IL in the circuit of Fig. 1A.

Third Embodiment

A noise suppression circuit according to a third embodiment of the invention will now be described. The noise suppression circuit according to the third embodiment is a circuit for suppressing common-mode noise having the same phase and propagating through two conductive lines.

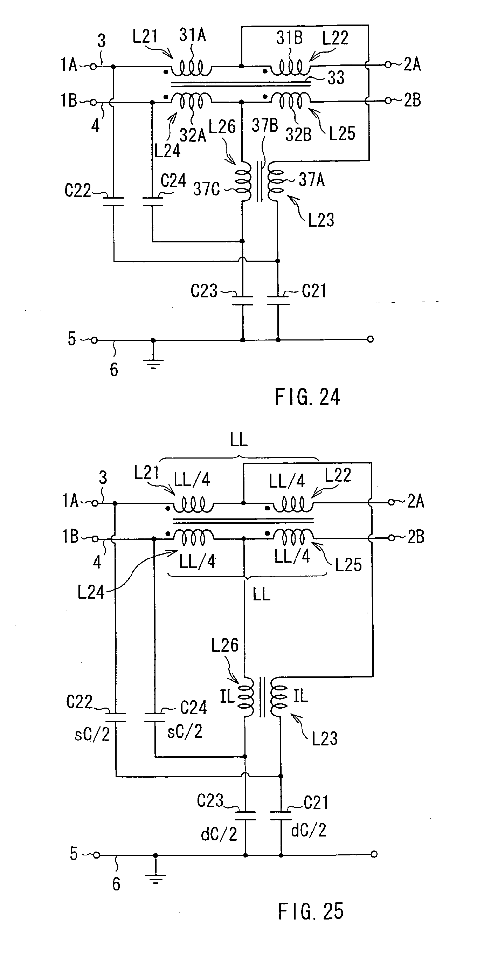

Fig. 24 shows a configuration example of the noise suppression circuit according to the third embodiment of the invention. The same reference numerals are designated to components substantially the same as those of the noise suppression circuit of the first embodiment. The noise suppression circuit has a ground terminal 5 and a ground line 6 connected to the ground terminal 5. The noise suppression circuit further includes first and second inductors L21 and L22 inserted in series in the first conductive line 3, and a first series circuit in which a third inductor L23 and a first capacitor C21 are connected in series, the third inductor L23 side is connected between the first and second inductors L21 and L22, and the first capacitor C1 side is grounded. The noise suppression circuit further includes a second capacitor C22 whose one end is connected to the first conductive line 3 on the first inductor L21 side and whose other end is connected between the third inductor L23 and the first capacitor C21 in the first series circuit.

The noise suppression circuit further includes fourth and fifth inductors L24 and L25 inserted in series in the second conductive line 4 and suppressing common-mode noise in cooperation with the first and second inductors L21 and L22. The noise suppression circuit further includes a second series circuit in which a sixth inductor L26 and a third capacitor C23 are connected in series, the sixth inductor L26 side is connected between the fourth and fifth inductors L24 and L25, and the third capacitor C23 side is grounded. The noise suppression circuit further includes a fourth capacitor C24 whose one end is connected to the second conductive line 4 on the fourth inductor L24 side and whose other end is connected between the sixth inductor L26 and the third capacitor C23 in the second series circuit.

Although not shown, one end of the second capacitor C22 may be connected to the second inductor L22 side, not the first inductor L21 side, and one end of the fourth capacitor C24 may be connected to the fifth inductor L25 side, not the fourth inductor L24 side. Specifically, one end of the second capacitor L22 and one end of the fourth capacitor C24 may be connected to the same side so as to correspond to each other, on the signal input side or the output side. However, it is preferable to connect one end of each of the second and fourth capacitors C22 and C24 to the signal input side for the reason that the circuit functions excellent particularly when the impedance becomes low at the noise source.

The third and sixth inductors L23 and L26 in the first and second series circuits are magnetically coupled to each other via windings 37A and 37C wound around a common core 37B. The magnetic coupling is not always necessary. In the case where the inductors are not magnetically coupled, the polarity directions in the third and sixth inductors L23 and L26 are not limited. In the first and second series circuits, the first and third capacitors C21 and C23 function as high-pass filters for passing a normal-mode signal having a frequency equal to or higher than a predetermined value.

The first and second inductors L21 and L22 are electromagnetically coupled to each other in the same polarity. Similarly, the fourth and fifth inductors L24 and L25 are also electromagnetically coupled to each other in the same polarity and are electromagnetically coupled to the first and second inductors L21 and L22 in the same polarity. The first and second inductors L21 and L22 have windings 31A and 31B, respectively, wound in the same direction around a common core 33. Similarly, the fourth and fifth inductors L24 and L25 have windings 32A and 32B, respectively, wound in the same direction around the common core 33. Although the inductors may be formed by different windings as described above, like the first and second inductors L1 and L2 in the circuit of Fig. 1A, they can be also formed by a single winding. The windings are wound around the common core 33, thereby coupling to each other so as to suppress common-node noise in cooperation with each other. That is, the windings are wound around the core 33 in the directions so that magnetic fluxes induced by the magnetic core 33 cancel out each other by the currents flowing in the windings when current in the normal mode flows in the windings. The windings and the core 33 form a common-mode choke coil that suppresses the common-mode noise and passes the normal-mode signal. Alternatively, the windings 31A and 31B and the windings 32A and 32B can be wound around different cores without being coupled to each other. In this case, as compared with the case where the windings 31A and 31B and the windings 32A and 32B are coupled to each other, the normal-mode noise can be suppressed.

Preferably, the inductance of the first and second inductors L21 and L22 has the same value and, similarly, the inductance of the fourth and fifth inductors L24 and L25 has the same value. More preferably, all of the inductance of the first and second inductors L21 and L22 and the fourth and fifth inductors L24 and L25 has the same value.

Next, the action of the noise suppression circuit according to the embodiment will be described. First, ideal operation of a circuit section excluding the second and fourth capacitors C22 and C24, that is, a basic circuit section for noise suppression will be described. It is assumed that the inductance of the first and second inductors L21 and L22 has the same value, and the coupling coefficient is 1. The inductance of the fourth and fifth inductors L24 and L25 also has the same value, and the coupling coefficient is 1. The impedance of each of the first and third capacitors C21 and C23 in the series circuit is so low as to be ignorable.

First, the case where a voltage Vi in the normal mode is applied to the terminals 1A and 1B will be described. In this case, the equal voltage Vi is generated between one end (the end on the terminal 1A side) of the first inductor L21 and the earth and between one end (the end on the terminal 1B side) of the fourth inductor L24 and the earth. The voltage Vi generated between one end of the first inductor L21 and the earth is divided by the first inductor L21 and the third inductor L3 in the first series circuit, so that a predetermined voltage develops across the first inductor L21 and across the first series circuit. Similarly, the voltage Vi generated between one end of the fourth inductor L24 and the earth is divided by the fourth inductor L24 and the sixth inductor L26 in the second series circuit, so that a predetermined voltage develops across the fourth inductor L24 and across the second series circuit. Since the first inductor L21 and the second inductor L22 are electromagnetically coupled to each other, a predetermined voltage develops across the second inductor L22 in accordance with the voltage generated across the first inductor L21. The voltage between the other end (the end on the terminal 2A side) of the second inductor L22 and the earth, that is, the voltage Vo between the terminal 2A and the earth is expressed by the sum of the voltage generated in the second inductor L22 and the voltage generated in the first series circuit. Since the voltages have the opposite polarities, they cancel out each other. As a result, the resultant voltage becomes lower than the voltage generated between one end of the first inductor L21 and the ground, that is, the voltage Vi generated between the terminal 1A and the earth.

Similarly, since the fourth and fifth inductors L24 and L25 are electromagnetically coupled to each other, a predetermined voltage develops across the fifth inductor L25 in accordance with the voltage generated across the fourth inductor L24. As a result, the voltage between the other end of the fifth inductor L25 and the earth, that is, the voltage Vo between the terminal 2B and the earth becomes lower than the voltage generated between one end of the fourth inductor L24 and the earth, that is, the voltage Vi generated between the terminal 1B and the earth. In the case where a voltage in the common mode is applied to the terminals 1A and 1B, the voltage in the common mode generated in the terminals 2A and 2B becomes lower than the voltage in the common mode applied to the terminals 1A and 1B.

In the circuit, also in the case where the voltage in the common mode is applied to the terminals 2A and 2B, in a manner similar to the above, the voltage in the common mode generated in the terminals 1A and 1B becomes lower than that applied to the terminals 2A and 2B. In such a manner, ideally, the common-mode noise can be suppressed in both of the case where the common-mode noise applied to the terminals 1A and 1B and the case where the common-mode noise applied to the terminals 2A and 2B.

However, under actual circuit conditions, the stray capacitance Cx exists in parallel with each of the first and second inductors L21 and L22 and the fourth and fifth inductors L24 and L25. Through paths are formed by the stray capacitance Cx and disturb the above-described ideal noise suppressing operation. In the case where input and output impedances of signals fluctuate with time and, particularly, the impedance becomes high, the action of the inductance components of the first and second inductors L21 and L22 and the fourth and fifth inductors L24 and L25 becomes weaker and it disturbs the noise suppressing operation particularly in a high frequency range. By the second and fourth capacitors C22 and C24, the problems are solved and excellent noise suppressing operation is realized. For example, by providing the second capacitor C22, a new signal path extending from the first conductive line 3 to the first series circuit side is formed. For example, when the impedance becomes high and the action of the inductance components of the first and second inductors L21 and L22 becomes weak, a part of current flowing from the terminal 1A side to the terminal 2A side via the first and second inductors L21 and L22 passes through the second capacitor C22. Consequently, the current flowing to the terminal 2A side is reduced, and deterioration in the characteristics caused by weakening of the action of the inductance component is prevented. The fourth capacitor C24 also similarly acts on the fourth and fifth inductors L24 and L25.

By adjusting the inductance IL of the third and sixth inductors L23 and L26 in the first and second series circuits and the capacitance sC of the second and fourth capacitors C22 and C24 so as to satisfy the following conditions, excellent characteristics adapted to all of impedances are obtained. Specifically, as also shown in Fig. 25, when each of the overall inductance of a combination of the first and second inductors L21 and L22 and the overall inductance of a combination of the fourth and fifth inductors L24 and L25 is LL, each of the inductance of the third inductor L23 in the first series circuit and the inductance of the sixth inductor L26 in the second series circuit is IL, each of the capacitance of the first capacitor C21 in the first series circuit and the capacitance of the third capacitor C23 in the second series circuit is dC, and each of the capacitance of the second capacitor C22 and the capacitance of the fourth capacitor C24 is sC, preferably, the inductance of the first and second inductors L21 and L22 and the inductance of the fourth and fifth inductors L24 and L25 is LL/4 and has the same value, and the following conditions are satisfied.

$$0 < IL < LL/4 \ldots (A\text{-}5)$$

$$0 < sC < dC \quad \ldots (B\text{-}5)$$

Fig. 25 shows the values of sC and dC for obtaining excellent characteristics using the values of sC and dC in the circuit of Fig. 1A as a reference. As shown in the diagram, it is preferable to set the value of sC to the half of the value sC in the circuit of Fig. 1A and to set the value dC to the half of the value dC in the circuit of Fig. 1A.

The characteristics of the noise suppression circuit of the embodiment are similar to those of the noise suppression circuit of the first embodiment except for the difference between the normal mode and the common mode. Therefore, the noise suppression circuit of the third embodiment can effectively suppress common-mode noise in a wide frequency range with a relatively simple configuration obtained only by adding two series circuits each made by an inductor and a capacitor to a common-mode choke coil without using a coil having large inductance. Since the second capacitor C22 is connected to the first conductive line 3 and the first series circuit, the fourth capacitor C24 is connected to the second conductive line 4 and the second series circuit, and new signal paths extending from the first and second conductive lines 3 and 4 to the first and second series circuits via the second and fourth capacitors C22 and C24, respectively, are formed, even if the impedance fluctuates on the input side or the output side, deterioration in the signal characteristics due to the fluctuation is suppressed, and common-mode noise can be suppressed effectively in a wide frequency range. The other configurations, actions, and effects in the third embodiment are similar to those of the first embodiment.

Performance Comparison among Circuits of Embodiments

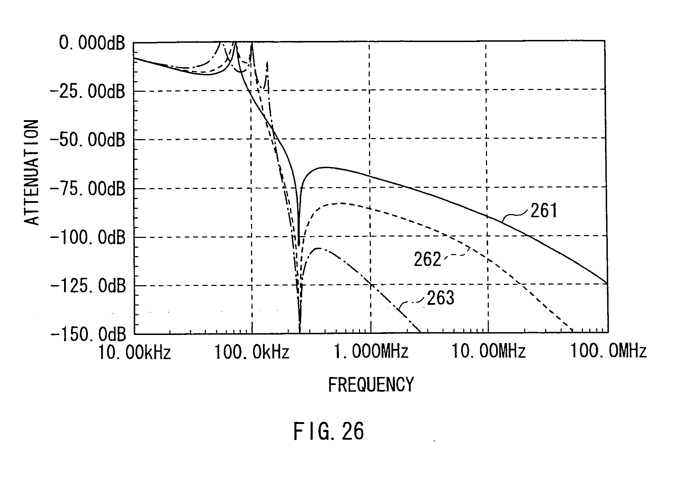

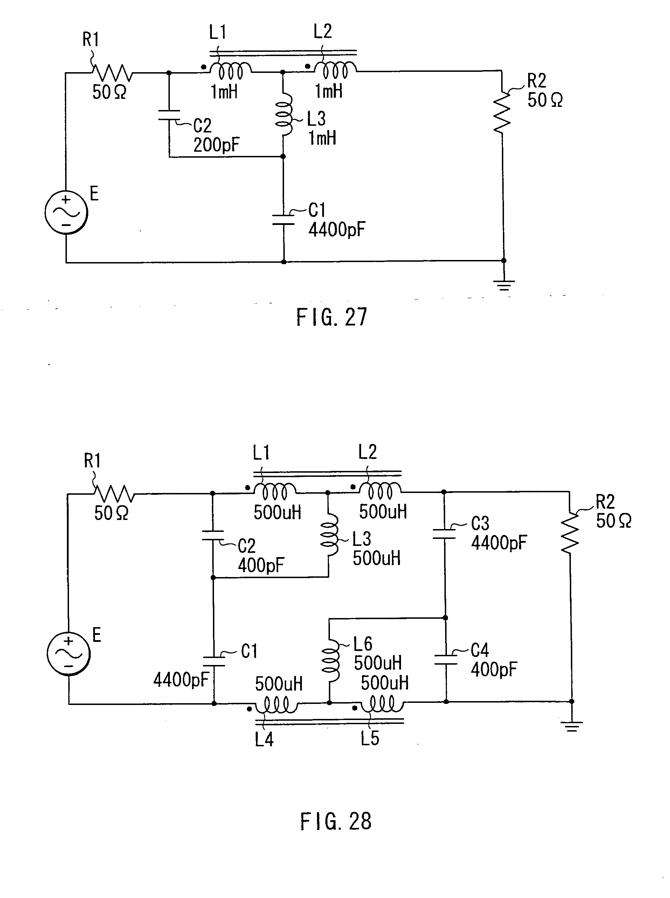

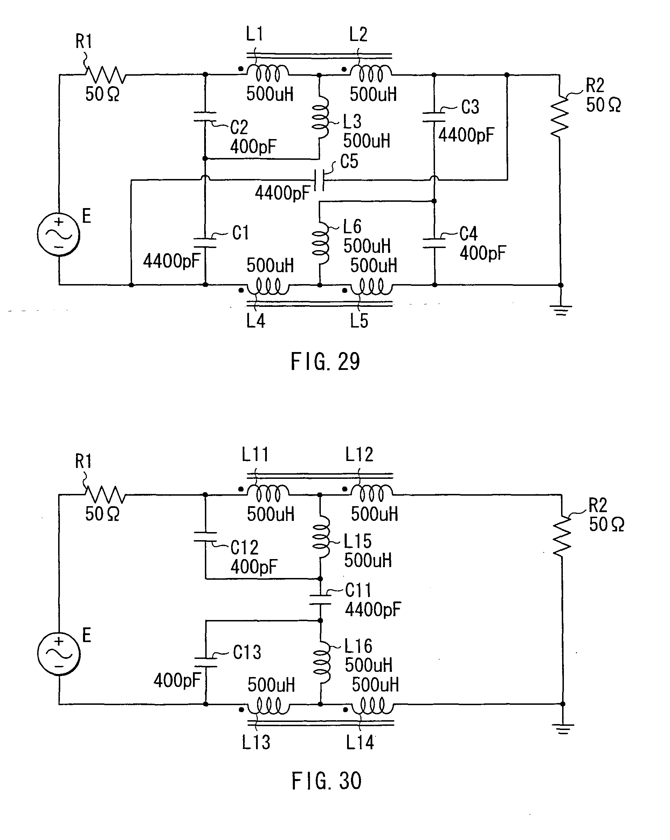

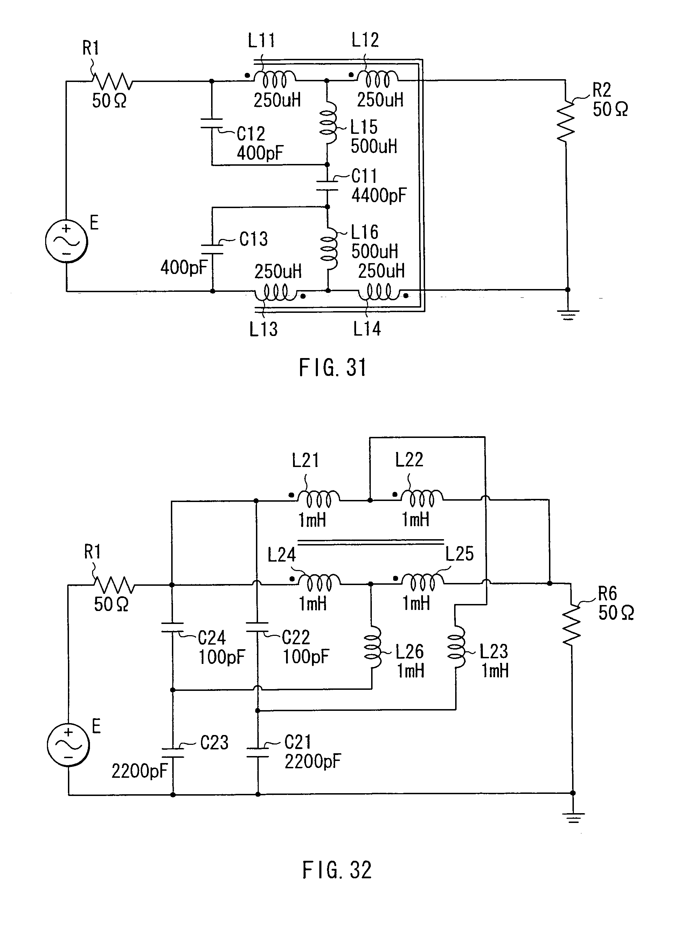

Fig. 26 shows results of performance comparison among the noise suppression circuits of the embodiments by a simulation. In Fig. 26, the axis of abscissa indicates frequency, and the axis of ordinate indicates the attenuation. Figs. 27 to 32 show circuit configurations and circuit values used for the simulation. The circuit of Fig. 27 corresponds to the circuit configuration of the first embodiment of Fig. 1A. The circuit of Fig. 28 corresponds to the circuit configuration of the first modification of the first embodiment of Fig. 16. The circuit of Fig. 29 corresponds to the circuit configuration of the second modification of the first embodiment of Fig. 18. The circuit of Fig. 30 corresponds to the circuit configuration of the second embodiment of Fig. 20. The circuit of Fig. 31 corresponds to the circuit configuration of a modification of the second embodiment of Fig. 22. The circuit of Fig. 32 corresponds to the circuit configuration of the third embodiment of Fig. 24. In Figs. 27 to 32, R indicates impedance of an input or output.

In Fig. 26, the curve indicated by reference numeral 262 shows the characteristic of the circuit configuration of Fig. 28. The curve indicated by reference numeral 263 shows the characteristic of the circuit configuration of Fig. 29. The curve indicated by reference numeral 261 shows the characteristic of the circuit configuration other than the circuit configurations of Figs. 28 and 29. It is understood from the simulation result of Fig. 6 that the circuit conditions by which the same characteristics as those of the unbalanced normal-mode noise suppression circuit of Fig. 27 (Fig. 1A) as a reference are obtained exist in the balanced normal-mode noise suppression circuits of Figs. 30 and 31 (Figs. 20 and 22) and the common-mode noise suppression circuit of Fig. 32 (Fig. 24). It is understood from the curves 262 and 263 that in the modified circuits (Figs. 16 and 18) of the balanced normal-mode noise suppression circuits of Figs. 28 and 29, circuit conditions by which characteristics are improved as compared with the unbalanced normal-mode noise suppression circuit of Fig. 27 as a reference exist.

The noise suppression circuits according to the foregoing embodiments can be used as means for reducing ripple voltage generated by a power converter or noise or means for reducing noise on a power line in a power line communication or preventing a communication signal on an indoor power from leaking to an outdoor power line.

The present invention is not limited to the foregoing embodiments but can be variously modified. For example, the noise suppression circuit of the present invention may have the normal-mode noise suppression circuit of the first or second embodiment and the common-mode noise suppression circuit of the third embodiment.

**Claims**

1. A noise suppression circuit suppressing normal-mode noise transmitted on first and second conductive lines and causing a potential difference between the first and the second conductive lines, comprising:

   first and second inductors inserted in series in the first conductive line and electromagnetically coupled to each other;
   a first series circuit in which a third inductor and a first capacitor are connected in series, the third inductor side of the first series circuit is connected between the first and second inductors, and the first capacitor side of the first series circuit is connected to the second conductive line; and
   a second capacitor whose one end is connected to the first conductive line on one end side of a series inductor section configured of the first and the second inductors and whose other end is connected between the third inductor and the first capacitor in the first series circuit.

2. The noise suppression circuit according to claim 1, wherein the inductance of the first inductor and the inductance of the second inductor has the same value.

3. The noise suppression circuit according to claim 2, wherein when overall inductance of a combination of the first and second inductors is LL,
   the inductance of the third inductor in the first series circuit is IL,
   the capacitance of the first capacitor in the first series circuit is dC, and
   the capacitance of the second capacitor is sC,
   the inductance of the first and second inductors is LL/4 and has the same value, and the following conditions are satisfied.

$$0<IL<LL/4 \ ... \ (A\text{-}1)$$

$$0<sC<dC \ ... \ (B\text{-}1)$$

4. The noise suppression circuit according to claim 1, further comprising:

fourth and fifth inductors inserted in series in the second conductive line and electromagnetically coupled to each other;
a second series circuit in which a sixth inductor and a third capacitor are connected in series, the sixth inductor side of the second series circuit is connected between the fourth and fifth inductors, and the third capacitor side of the second series circuit is connected to the first conductive line; and
a fourth capacitor whose one end is connected to the second conductive line on one end side of a series inductor section configured of the fourth and the fifth inductors and whose other end is connected between the sixth inductor and the third capacitor in the second series circuit, wherein the first capacitor side of the first series circuit is connected to the second conductive line on the opposite side of a series inductor section configured of the fourth and fifth inductors from the side to which one end of the fourth capacitor is connected, and
the third capacitor side of the second series circuit is connected to the first conductive line on the opposite side of a series inductor section configured of the first and second inductors from the side to which one end of the second capacitor is connected.

5. The noise suppression circuit according to claim 4, wherein the inductance of the first and second inductors and the inductance of the fourth and fifth inductors has the same value.

6. The noise suppression circuit according to claim 5, wherein when the sum of overall inductance of a combination of the first and second inductors and overall inductance of a combination of the fourth and fifth inductors is LL, each of the inductance of the third inductor in the first series circuit and the inductance of the sixth inductor in the second series circuit is IL, each of the capacitance of the first capacitor in the first series circuit and the capacitance of the third capacitor in the second series circuit is dC, and each of the capacitance of the second capacitor and the capacitance of the fourth capacitor is sC, the inductance of the first and second inductors and the inductance of the fourth and fifth inductors is LL/8 and has the same value, and the following conditions are satisfied.

$$0<IL/2<LL/8 \qquad ... \ (A\text{-}2)$$

$$0<sC<dC \quad ... \ (B\text{-}2)$$

7. The noise suppression circuit according to claim 4, further comprising a fifth capacitor whose one end is connected to the second conductive line on the first capacitor side of the first series circuit, and whose other end is connected to the first conductive line on the third capacitor side of the second series circuit.

8. A noise suppression circuit suppressing normal-mode noise transmitted on first and second conductive lines and causing a potential difference between the first and the second conductive lines, comprising:

first and second inductors inserted in series in the first conductive line and electromagnetically coupled to each other;
third and fourth inductors inserted in series in the second conductive line and electromagnetically coupled to each other;
a series circuit including a fifth inductor whose one end is connected between the first and second inductors, a first capacitor whose one end is connected to the other end of the fifth inductor, and a sixth inductor whose one end is connected to the other end of the first capacitor and whose other end is connected between the third and fourth inductors;
a second capacitor whose one end is connected to the first conductive line on one side of a series inductor section configured of the first and the second inductors and whose other end is connected between the fifth inductor and the first capacitor in the series circuit; and
a third capacitor whose one end is connected to the second conductive line on one side of a series inductor section configured of the third and the forth inductors, the one side corresponding to a connection point of the second capacitor to the first conductive line, and whose other end is connected between the sixth inductor and the first capacitor in the series circuit.

**9.** The noise suppression circuit according to claim 8, wherein the inductance of the first and second inductors and the inductance of the third and fourth inductors has the same value.

**10.** The noise suppression circuit according to claim 9, wherein when the sum of overall inductance of a combination of the first and second inductors and overall inductance of a combination of the third and fourth inductors is LL, each of the inductance of the fifth inductor and the inductance of the sixth inductor in the series circuit is IL, the capacitance of the first capacitor in the series circuit is dC, and each of the capacitance of the second capacitor and the capacitance of the third capacitor is sC, the inductance of the first and second inductors and the inductance of the third and fourth inductors is LL/8 and has the same value, and the following conditions are satisfied.

$$0 < IL/2 < LL/8 \quad \dots (A\text{-}3)$$

$$0 < sC < dC/2 \dots (B\text{-}3)$$

**11.** The noise suppression circuit according to claim 8, wherein the first and second inductors and the third and fourth inductors are electromagnetically coupled to each other.

**12.** The noise suppression circuit according to claim 11, wherein when the overall inductance of a combination of the first and second inductors and the third and fourth inductors is LL, each of the inductance of the fifth inductor and the inductance of the sixth inductor in the series circuit is IL, the capacitance of the first capacitor in the series circuit is dC, and each of the capacitance of the second capacitor and the capacitance of the third capacitor is sC, the inductance of the first and second inductors and the inductance of the third and fourth inductors is LL/8 and has the same value, and the following conditions are satisfied.

$$0 < IL/2 < LL/8 \quad \dots (A\text{-}4)$$

$$0 < sC < dC/2 \dots (B\text{-}4)$$

**13.** A noise suppression circuit suppressing common-mode noise transmitted in the same phase on first and second conductive lines, comprising:

first and second inductors inserted in series in the first conductive line and electromagnetically coupled to each other; a first series circuit in which a third inductor and a first capacitor are connected in series, the third inductor side of the first series circuit is connected between the first and second inductors, and the first capacitor side of the first series circuit is grounded; a second capacitor whose one end is connected to the first conductive line on one side of a series inductor section configured of the first and the second inductors and whose other end is connected between the third inductor and the first capacitor in the first series circuit; fourth and fifth inductors inserted in series in the second conductive line, magnetically coupled to the first and second inductors, and electromagnetically coupled to each other; a second series circuit in which a sixth inductor and a third capacitor are connected in series, the sixth inductor side of the second series circuit is connected between the fourth and fifth inductors, and the third capacitor side of the second series circuit is grounded; and a fourth capacitor whose one end is connected to the second conductive line on one side of a series inductor section configured of the forth and the fifth inductors, the one side corresponding to a connection point of the second capacitor to the first conductive line, and whose other end is connected between the sixth inductor and the third capacitor in the second series circuit.

**14.** The noise suppression circuit according to claim 13, wherein the third and sixth inductors are magnetically coupled to each other.

**15.** The noise suppression circuit according to claim 13, wherein the inductance of the first and second inductors and the inductance of the fourth and fifth inductors has the same value.

**16.** The noise suppression circuit according to claim 15, wherein when each of the overall inductance of a combination of the first and second inductors and the overall inductance of a combination of the fourth and fifth inductors is LL, each of the inductance of the third inductor in the first series circuit and the inductance of the sixth inductor in the second series circuit is IL,
each of the capacitance of the first capacitor in the first series circuit and the capacitance of the third capacitor in the second series circuit is dC, and each of the capacitance of the second capacitor and the capacitance of the fourth capacitor is sC, the inductance of the first and second inductors and the inductance of the fourth and fifth inductors is LL/4 and has the same value, and the following conditions are satisfied.

$$0 < IL < LL/4 \ldots (A\text{-}5)$$

$$0 < sC < dC \quad \ldots (B\text{-}5)$$

FIG. 1A

FIG. 1B

12  P1

3                    11

1A○——————————————————○2A

11A            11B

↑      ↑
L1      L2

FIG. 2

L1                    L2

3

1A○                              ○2A

V1          V2 (=V1)

Vi          C2    V3                Vo

L3

C1

1B○                              ○2B

4

FIG. 3

FIG. 4

FIG. 5

sC IS FIXED AT 0.05 μF WHILE IL IS ADJUSTED     Zi=Zo=50 Ω

IL=85uH

IL=90uH     IL=83.3uH     IL=82.5uH

FREQUENCY

FIG. 6

IL IS FIXED AT 83.3 μH WHILE sC IS ADJUSTED     Zi=Zo=50 Ω

sC=0.53uF     sC=0.051uF  sC=0.05uF  sC=0.0496uF

FREQUENCY

FIG. 7

50 Ω TRANSMISSION CHARACTERISTIC(WITH SHIFT IN sC)
dC=6600pF, LL=4mH

Legend:
—— IL=0.8mH sC=0
----- IL=0.8mH sC=200pF
········· IL=0.8mH sC=660pF
—·— IL=0.8mH sC=1640pF
—··— IL=0.8mH sC=2000pF

FIG. 8

EP 1 783 900 A1

FIG. 9

Zi, Zo=10Ω (EQUAL INPUT/OUTPUT IMPEDANCE)

FIG. 10

Zi, Zo=1kΩ (EQUAL INPUT/OUTPUT IMPEDANCE)

FIG. 11

OUTPUT SIDE IS FIXED AT 50 Ω AND
INPUT SIDE IS CHANGED Zi=10mΩ

FIG. 12

OUTPUT SIDE IS FIXED AT 50 Ω AND
INPUT SIDE IS CHANGED Zi=1kΩ

FIG. 13

INPUT SIDE IS FIXED AT 50Ω AND
OUTPUT SIDE IS CHANGED Zo=10mΩ

FIG. 14

INPUT SIDE IS FIXED AT 50Ω AND
OUTPUT SIDE IS CHANGED Zo=1kΩ

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

F I G. 31

F I G. 32

FIG. 33

FIG. 34

## INTERNATIONAL SEARCH REPORT

| | International application No. |
|---|---|
| | PCT/JP2005/014565 |

| A. CLASSIFICATION OF SUBJECT MATTER |
|---|
| *H03H7/09* (2006.01), *H04B3/56* (2006.01) |

According to International Patent Classification (IPC) or to both national classification and IPC

| B. FIELDS SEARCHED |
|---|
| Minimum documentation searched (classification system followed by classification symbols) |
| *H03H5/00* (2006.01)-*H03H7/12* (2006.01), *H04B1/18* (2006.01), *H04B3/54* (2006.01), |

Documentation searched other than minimum documentation to the extent that such documents are included in the fields searched
Jitsuyo Shinan Koho      1922-1996   Jitsuyo Shinan Toroku Koho   1996-2005
Kokai Jitsuyo Shinan Koho   1971-2005   Toroku Jitsuyo Shinan Koho   1994-2005

Electronic data base consulted during the international search (name of data base and, where practicable, search terms used)
WPI/L

### C. DOCUMENTS CONSIDERED TO BE RELEVANT

| Category* | Citation of document, with indication, where appropriate, of the relevant passages | Relevant to claim No. |
|---|---|---|
| Y | JP 10-200357 A  (Taiyo Yuden Co., Ltd.), | 1-3,8-13, |
|   | 31 July, 1998 (31.07.98), | 15-16 |
| A | Full text; all drawings | 4-7,14 |
|   | (Family: none) | |
| | | |
| Y | JP 40-7241 B1  (Siemens und Haruske AG.), | 1-3,8-13, |
|   | 12 April, 1965 (12.04.65), | 15-16 |
| A | Page 3, right column, lines 25 to 33; Fig. 10 | 4-7,14 |
|   | (Family: none) | |
| | | |
| A | JP 63-135008 A  (Matsushita Electric Works, Ltd.), | 7 |
|   | 07 June, 1988 (07.06.88), | |
|   | Fig. 3 | |
|   | (Family: none) | |

| [X] Further documents are listed in the continuation of Box C. | [ ] See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 04 November, 2005 (04.11.05) | 22 November, 2005 (22.11.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| International application No. |
|---|
| PCT/JP2005/014565 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2002-204137 A  (Mitsubishi Electric Corp.),<br>19 July, 2002 (19.07.02),<br>Figs. 3, 7<br>(Family: none) | 8-12 |
| Y | JP 10-84669 A  (Fuji Electric Co., Ltd.),<br>31 March, 1998 (31.03.98),<br>Fig. 4<br>(Family: none) | 11 |
| Y | JP 3053334 U  (Tsuruo SHIMAYAMA),<br>27 October, 1998 (27.10.98),<br>Figs. 1, 5<br>(Family: none) | 13,15,16 |
| A | JP 2003-198307 A  (Murata Mfg. Co., Ltd.),<br>11 July, 2003 (11.07.03),<br>Par. No. [0030]; Fig. 4<br>& US 2003/0076199 A1    & CN 1413051 A<br>& DE 10248477 A1 | 1-16 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H5121988 A
- JP H10200357 A